(19) Europäisches Patentamt
European Patent Office
Office européen des brevets

(11) Publication number: **0 380 223 A1**

# (12) EUROPEAN PATENT APPLICATION

(21) Application number: **90300421.6**

(22) Date of filing: **15.01.90**

(30) Priority: **17.01.89 JP 9538/89**
**29.03.89 JP 79301/89**
**18.04.89 JP 99350/89**

(43) Date of publication of application:
**01.08.90 Bulletin 90/31**

(84) Designated Contracting States:
**DE FR GB**

(51) Int. Cl.5: **G03C 7/12, H01L 31/0216, G02F 1/1335**

(71) Applicant: **KONICA CORPORATION**
**26-2, Nishishinjuku 1-chome Shinjuku-ku**
**Tokyo 160(JP)**

(72) Inventor: **Yoshiharu, Mochizuki**
**c/o Konica Corporation, No 1 Sakura-Machi**
**Hino-shi, Tokyo 191(JP)**
Inventor: **Okauchi, Ken**
**c/o Konica Corporation, No 1 Sakura-Machi**
**Hino-shi, Tokyo 191(JP)**

(74) Representative: **Brock, Peter William et al**
**URQUHART-DYKES & LORD 91 Wimpole Street**
**London W1M 8AH(GB)**

## (54) Colour filter and process for producing the same.

(57) A color filter having a plurality of pixels of different colors on a light-transmissive substrate is disclosed. At least one of said pixels contains a dye formed from a dye-forming coupler in a developer and 0.1 -20 mg/dm$^2$ of a high-boiling point organic solvent. Also disclosed is a process for producing such improved color filter.

EP 0 380 223 A1

# COLOR FILTER AND PROCESS FOR INTRODUCING THE SAME

## BACKGROUND OF THE INVENTION

The present invention relates to a color filter and a process for producing the same. More particularly, the present invention relates to a color filter suitable for use not only with a liquid-crystal color display but also with an image tube, as well as to a process for producing such a color filter.

While many processes are known that are capable of producing color filters, the method described in Unexamined Published Japanese Patent Application No. 55-6342 involves color development of a color silver salt light-sensitive material with a coupler-containing developer. However, the color filter produced by this method is not capable of completely faithful color reproduction and its heat resistance also is not high. With a view to solving these problems, the present inventors proposed a process for producing a color filter capable of faithful color reproduction by using a pyrazoloazole compound as a magenta coupler but the result was not completely satisfactory.

Another problem with the method described in Unexamined Published Japanese Patent Application No. 55-6342 is that a relief occurs between pixels having different spectral characteristics and that this relief is a major cause of image deterioration after the fabrication of a liquid-crystal color display. In a liquid-crystal color display, spectral characteristics due to the orientation of the molecules of a liquid-crystal are determined by the voltage applied to the liquid-crystal layer, which voltage is dependent on the thickness of said layer. Thus, a difference in the thickness of adjacent pixels in color filter will cause image deterioration in which the spectral characteristics of individual pixels in a fabricated liquid-crystal color display deviate from desired ones.

## SUMMARY OF THE INVENTION

An object, therefore, of the present invention is to provide a process for producing a color filter that is improved not only in color reproduction but also in heat resistance.

Another object of the present invention is to provide a color filter having improved surface smoothness.

Still another object of the present invention is to provide a color filter that can be produced at low cost and which yet insures consistent performance.

Thus, according to one aspect, the present invention provides a color filter having a plurality of pixels of different colors on a light-transmissive substrate, at least one of said pixels containing a dye formed from a dye-forming coupler in a developer and 0.1 - 20 $mg/dm^2$ of a high-boiling point organic solvent.

According to its second aspect, the present invention provides a process for producing a color filter having a plurality of pixels of different colors on a support, which process includes at least one step of development with a color developer containing a dye-forming coupler in the presence of a high-boiling point organic solvent subsequent to patterned exposure of a light-sensitive material having a light-sensitive silver halide emulsion layer on a light-transmissive support.

## BRIEF DESCRIPTION OF THE DRAWINGS

Fig. 1 is a cross-sectional view showing an example of patterned exposure to be performed in the process of the present invention;

Fig. 2 is a cross section of an example of the color filter provided by the present invention;

Fig. 3 is a cross section of another example of the color filter provided by the present invention; and

Fig. 4 is a diagram showing in cross section an illustrative liquid-crystal color display using the color filter of the present invention.

## DETAILED DESCRIPTION OF THE INVENTION

The high-boiling point organic solvent (hereinafter abbreviated as HBS) to be contained in the color filter

of the present invention may be incorporated either in a pixel-forming light-sensitive emulsion layer or in a color developer or in both. Preferably, HBS is incorporated at least in a light-sensitive emulsion layer.

The term "high-boiling point organic solvent" as used herein means a compound having a boiling point not lower than 200° C. If a compound boiling below 200° C is used, it may be lost from a light-sensitive material by evaporation when a protective layer chiefly composed of polyimide or polyacrylamide is provided, which is the usual practice to perform after fabrication of a color filter. Exposure to elevated temperatures also occurs when a light-transparent electrode or an oriented film is provided on the color filter having a protective layer. Hence, the use of compounds having a boiling point below 200° C should be avoided in the practice of the present invention.

When incorporated in a light-sensitive emulsion layer, HBS is preferably used in an amount of 0.1 - 20 $mg/dm^2$, more preferably in an amount of 0.5 - 10 $mg/dm^2$. If HBS is to be used in combination with a compound represented by the general formula (IV) to be described hereinafter, the amount of HBS preferably ranges from 0.2 to 5 $mg/dm^2$. If it is to be incorporated in a color developer, HBS is preferably used in an amount of from 0.1 to 30 g, more preferably from 0.5 to 10 g, per liter of the developer.

Exemplary HBSs are esters such as phthalic acid esters and phosphoric acid esters, phenolic compounds, organic acid amides, and ketones. Among these HBSs, phthalic acid esters, phosphoric acid esters and phenolic compounds are preferred. Mixtures of two or more HBSs may be used in the present invention.

Preferred examples of phthalic acid esters are represented by the following general formula (I):

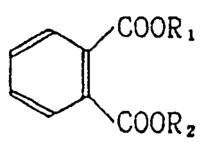

(I)

where $R_1$ and $R_2$ each represents an alkyl, alkenyl or aryl group, provided that the sum of carbon atoms in the groups represented by $R_1$ and $R_2$ ranges from 2 to 36, preferably from 6 to 24.

The alkyl group represented by each of $R_1$ and $R_2$ may be straight-chained or branched and is exemplified by butyl, pentyl, hexyl, heptyl, octyl, nonyl, decyl, undecyl, dodecyl, tridecyl, tetradecyl, pentadecyl, hexadecyl, heptadecyl, octadecyl, eicosyl, etc. The alkenyl group represented by each of $R_1$ and $R_2$ is exemplified by alkyl, hexenyl, heptenyl, octenyl, octadecenyl, etc. The aryl group represented by each of $R_1$ and $R_2$ is exemplified by phenyl, naphthyl, etc.

The alkyl, alkenyl and aryl group represented by each of $R_1$ and $R_2$ may individually have one or more substituents. Illustrative substituents on alkyl or alkenyl group include a halogen atom, as well as alkoxy, aryl, aryloxy, alkenyl and alkoxycarbonyl groups. Illustrative substituents on aryl group include a halogen atom, as well as alkyl, alkoxy, aryl, aryloxy, alkenyl and alkoxycrabonyl groups. Two or more of these substituents may be introduced as required.

Examples of phosphoric acid esters that may be used with advantage in the present invention are represented by the following general formula (II):

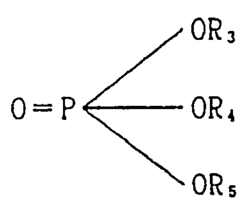

(II)

where $R_3$, $R_4$ and $R_5$ each represents an alkyl, alkenyl or aryl group, provided that the sum of carbon atoms in the groups represented by $R_3$, $R_4$ and $R_5$ ranges from 3 to 54.

The alkyl group represented by each of $R_3$, $R_4$ and $R_5$ may be straight-chained or branched and is specifically exemplified by those which are already listed as examples of the alkyl group represented by each of $R_1$ and $R_2$ in the general formula (I).

Examples of the alkenyl group represented by each of $R_3$, $R_4$ and $R_5$ include vinyl, allyl and butenyl groups. Examples of the aryl group represented by each of $R_3$, $R_4$ and $R_5$ include phenyl, tolyl and xylyl groups.

The alkyl, alkenyl, and aryl groups represented by each of $R_3$, $R_4$ and $R_5$ may have one or more substituents. Preferably, each of $R_3$, $R_4$ and $R_5$ represents an alkyl group such as butyl, 2-ethyl-hexyl, octyl, t-octyl, 3,5,5-trimethylhexyl, nonyl, decyl, sec-decyl, sec-dodecyl, etc.

Any of the known phenolic compounds may be used as HBS in the present invention but preferred examples are those which are solid at ordinary temperature (25° C) with a melting point not higher than 50° C or those which are liquid at ordinary temperature with a boiling point of at least 200° C at atmospheric pressure. In whichever case, the phenol is preferably substituted on 4-position by a group that will not be eliminated upon coupling so as to preclude reaction with the oxidation product of a color developing agent. Phenolic compounds having a non-diffusible group (hereunder referred to as a "ballast group") are more preferred and particularly preferred examples are represented by the following general formula (III):

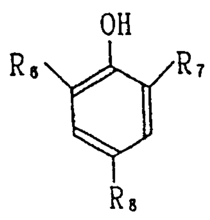

(III)

where $R_6$ and $R_7$ each represents a hydrogen atom or a straight-chained or branched alkyl group having 1 - 20 carbon atoms (e.g. methyl, ethyl, t-butyl, t-pentyl, t-octyl, dodecyl or pentadecyl), and $R_8$ represents a straight-chained or branched alkyl group having 1 - 20 carbon atoms (which may be the same as those listed above as examples of $R_6$ and $R_7$) or a cycloalkyl group (e.g. cyclopentyl or cyclohexyl), provided that the sum of carbon atoms in the groups represented by $R_6$, $R_7$ and $R_8$ ranges from 6 to 24.

The following are non-limiting representative examples of HBSs that can be used in the present invention:

HBS－1

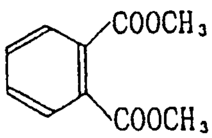

HBS－2

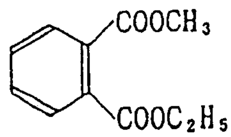

HBS－3

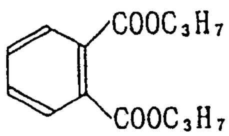

HBS－4

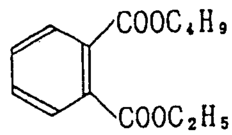

HBS－5

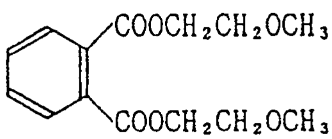

HBS－6

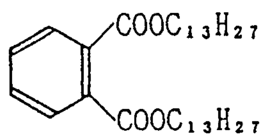

HBS－7

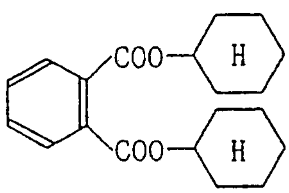

HBS－8

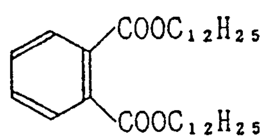

HBS－9

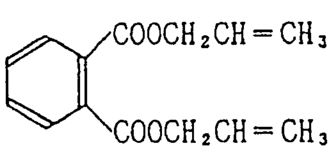

HBS－10

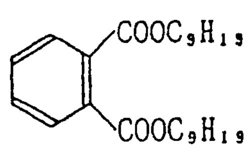

HBS－11

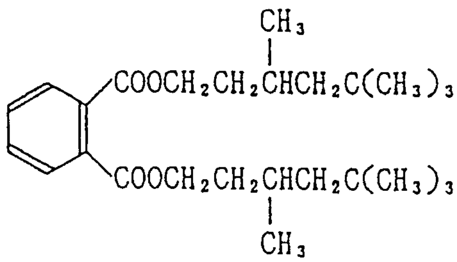

HBS－12

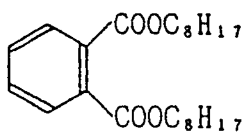

HBS－13

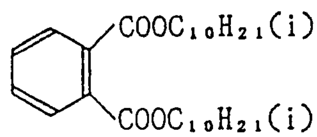

HBS－14

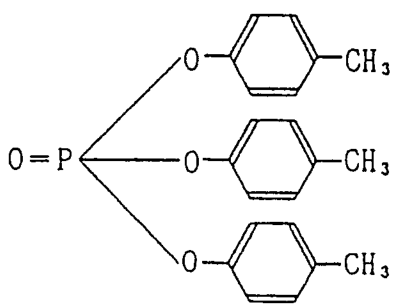

HBS－15

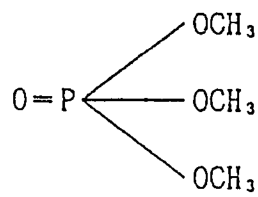

HBS－16

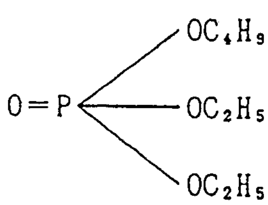

HBS－17

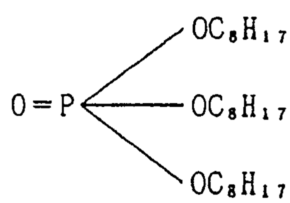

HBS-18

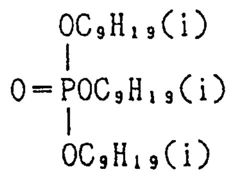

HBS-19

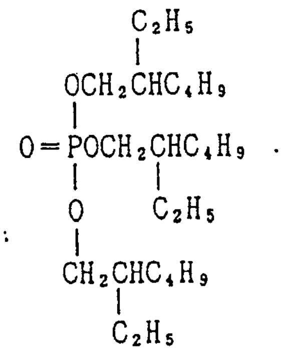

HBS-20

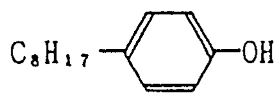

HBS-21

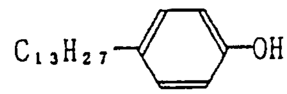

HBS-22

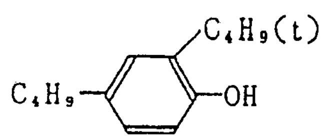

HBS-23

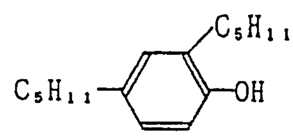

HBS-24

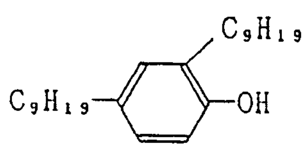

HBS-25

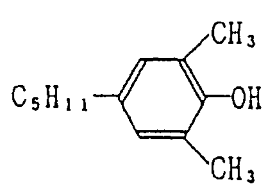

HBS-26

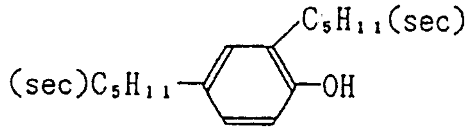

HBS-27

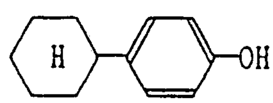

HBS－28

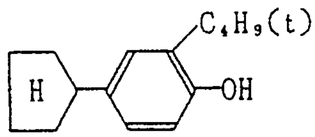

HBS－29

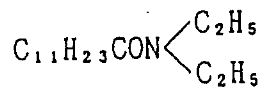

HBS－30

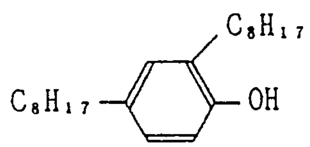

HBS－31

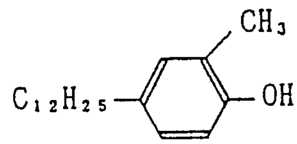

HBS－32

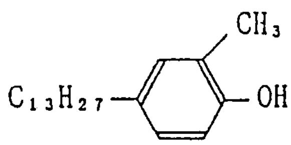

HBS－33

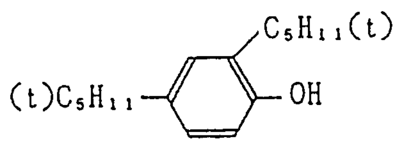

In the present invention, HBSs are preferably used as dispersion in hydrophilic colloids (e.g. gelatin), surfactants, water, etc.

In a preferred embodiment of the present invention, the color filter contains pixels of at least two colors, with said pixels of at least one color containing at least one substantially colorless compound that is formed upon coupling reaction between a precursor compound represented by the following general formula (IV) and the oxidized product of a color developing agent:

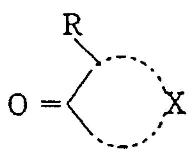

(IV)

where R represents an alkyl group (inclusive of a substituted alkyl group) or an aryl group (inclusive of a substituted aryl group) which are substituted on the active site, and X represents the atomic group necessary to form a 5- or 6-membered heterocyclic nucleus containing at least one nitrogen, sulfur or oxygen atom (said heterocyclic nucleus may either fuse to another ring or have a substituent on the ring).

The Weiss coupler represented by the general formula (IV) may optionally have a substituent on either the ring or the alkyl group represented by R, which substituent allows said compound to dissolve either totally or partly in a processing solution and has a molecular size and shape that renders said compound to be immobile in an emulsion layer after coupling with the oxidation product of a color developing agent. An illustrative substituent is an organic group having 6 - 24 carbon atoms.

More preferred examples of the Weiss coupler represented by the general formula (IV) are compounds that are represented by the following general formulas (1) to (8), with those represented by (1) and (2) being particularly preferred:

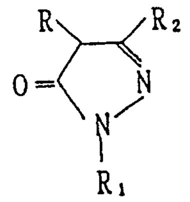

(1)

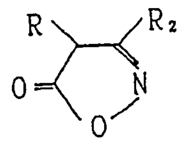

(2)

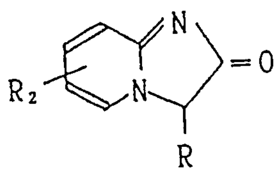

(3)

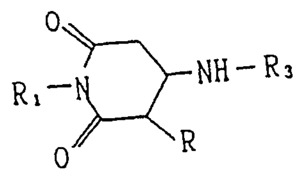

(4)

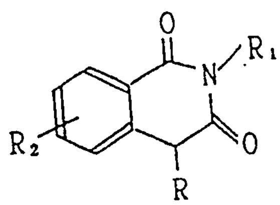

(5)

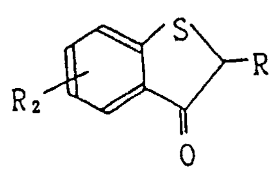

(6)

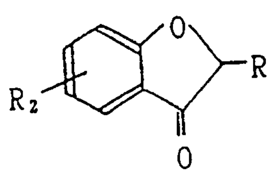

(7)

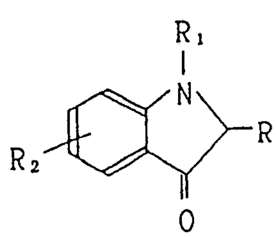

(8)

where R is the same as defined for the general formula (IV); $R_1$ is a substituted or unsubstituted alkyl or aryl group; $R_2$ is a substituted or unsubstituted alkyl, aryl, alkylamino, arylamino, acylamino, ureido, cyano or carbamoyl group, provided that R and $R_2$ or $R_3$ on adjacent positions may combine together to form a ring; $R_3$ is a substituted or unsubstituted alkyl or aryl group.

A more preferred Weiss coupler is included within the scope of the general formula (1) and may be represented by the following general formula (9):

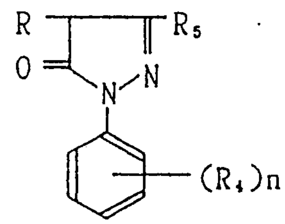

(9)

where R is the same as defined for the general formula (IV); $R_4$ is a hydrogen atom, a halogen atom, an alkyl, alkoxy, alkylamide, arylamide, alkylsulfonamido, arylsulfonamido, alkoxycarbonyl, carbamoyl or sulfamoyl group; $R_5$ is an alkyl group having no more than 8 carbon atoms, an aralkyl or aryl group having no more than 10 carbon atoms; n is an integer of 0 - 5, provided that the alkyl, alkoxy, aralkyl and aryl groups mentioned above may each have a substituent; preferred examples of $R_5$ may include methyl, ethyl, benzyl, phenethyl, phenyl, tolyl, etc.

Specific examples of the compound represented by the general formula (IV) that may be used in the present invention are listed below:

WE－1

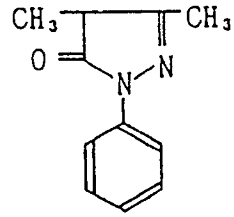

WE－2

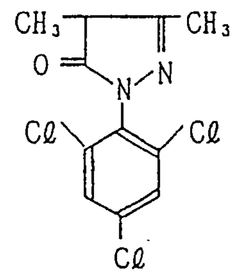

WE－3

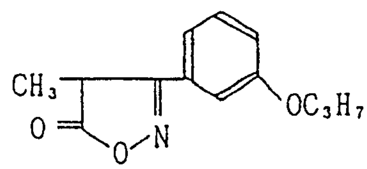

WE－4

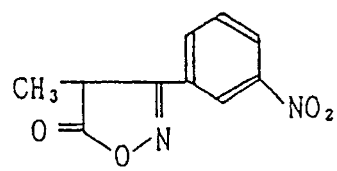

WE－5

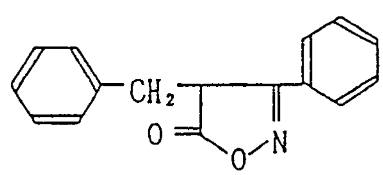

WE－6

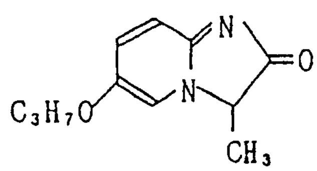

WE－7

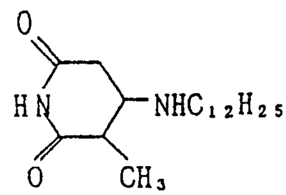

WE－8

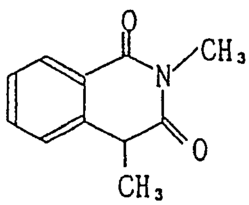

WE－9

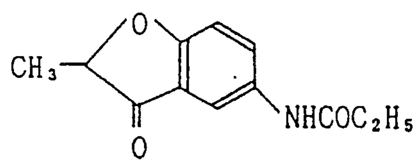

WE－10

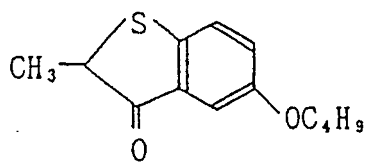

WE－11

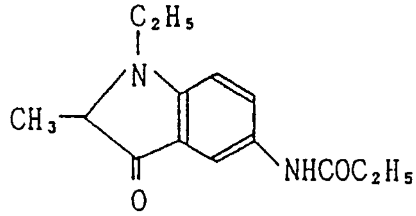

WE−12

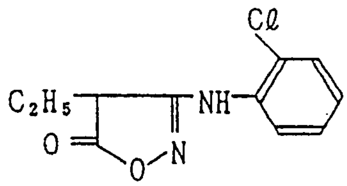

WE−13

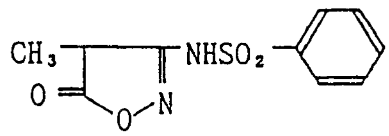

WE−14

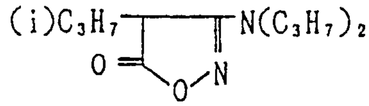

WE−15

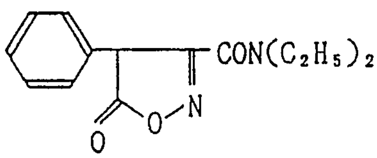

WE−16

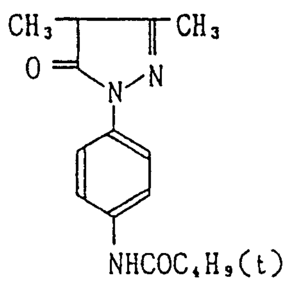

WE−17

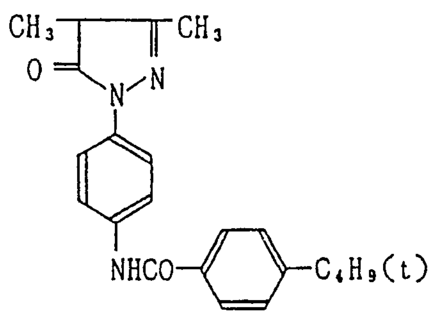

WE−18

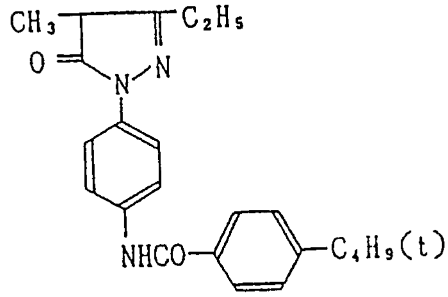

WE−19

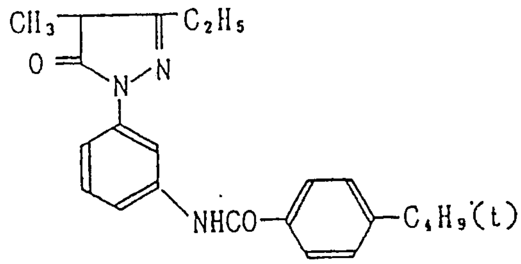

WE−20

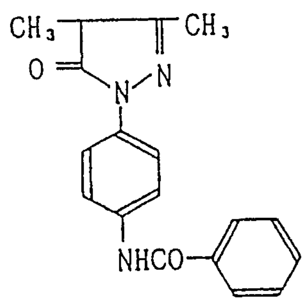

WE−21

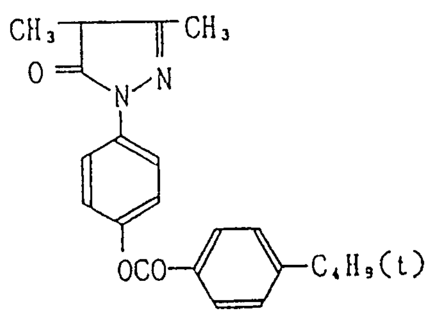

WE-22

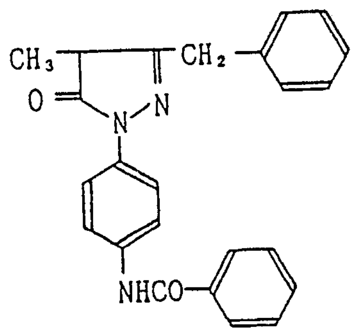

WE-23

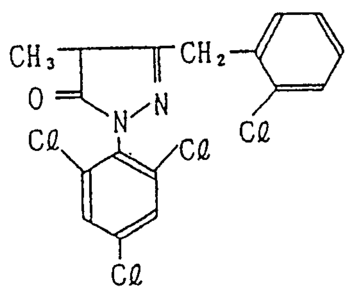

WE-24

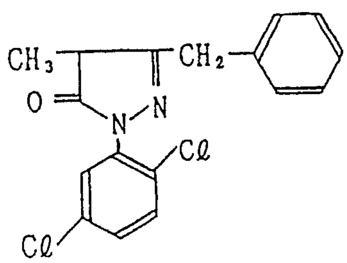

WE-25

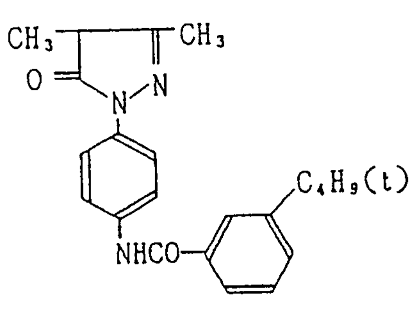

WE－26

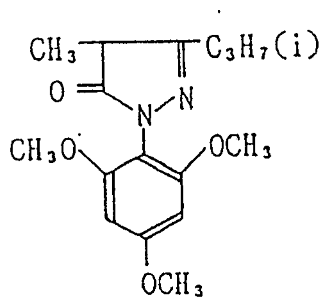

WE－27

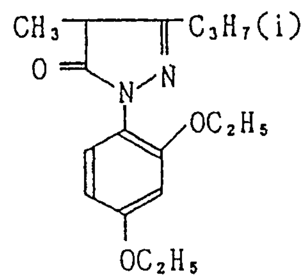

WE－28

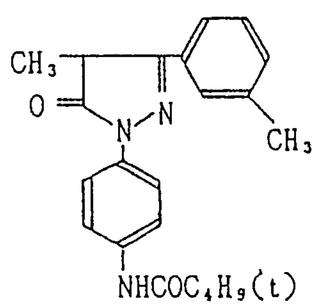

WE－29

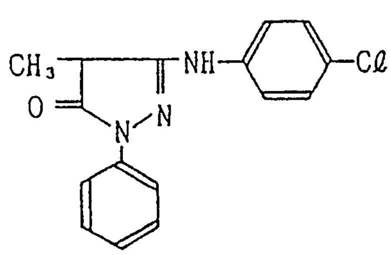

WE-30

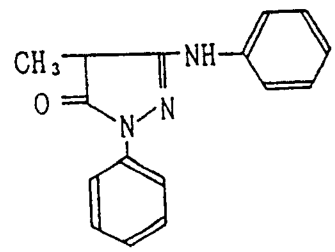

WE-31

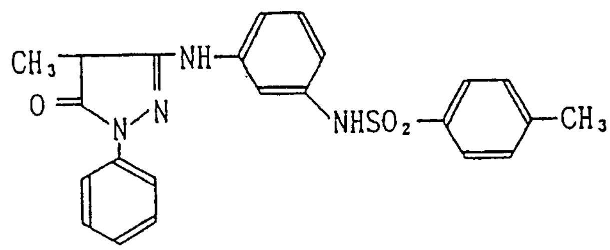

WE-32

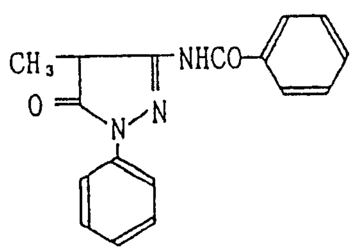

The Weiss coupler that may be used in the present invention is preferably incorporated in a processing solution, particularly in a developer. The processing solution in which the Weiss coupler is to be incorporated may be the same or different from a color developer or a black-and-white developer capable of bleaching silver salt dyes. However, in order to simplify the photographic process and to reduce the processing cost, the Weiss coupler containing solution is preferably the same as a color developer or a silver salt dye bleaching black-and-white developer.

The Weiss coupler is preferably used in an amount not exceeding 10 g per liter of the processing solution, with the range of 0.01 - 2 g being more preferred.

Silver halide light-sensitive material

The color filter of the present invention uses a silver halide light-sensitive material having a light-sensitive emulsion layer (hereinafter referred to simply as an "emulsion layer") formed by coating a silver halide emulsion on a light-transmissive substrate. The light-transmissive substrate used may be transparent or translucent as long as it is transmissive of light. The color filter may be exposed to high temperatures in such a step as forming a transparent electrode by evaporation, so the light-transmissive substrate is preferably made of a material having high heat resistance. Examples of the material of which the light-transmissive substrate is made include high-molecular weight compounds such as polyethylene terephthalate, polybutylene terephthalate, polystyrene, polycarbonate, polyethersulfone, polyvinyl alcohol and acetyl cellulose, glasses such as soda glass and borosilicate glass, and inorganic materials such as quartz and sapphire. Being made of these materials, the light-transmissive substrate may be used in such a form as a plate, sheet or film.

The thickness of the light-transmissive substrate may be properly determined in a accordance with the use and the material of which it is made and it is typically within the range of from 0.5 µm to 10 mm. If glass is used as the material of a light-transmissive substrate for liquid-crystal color display, its thickness is preferably within the range of from 0.3 to 2 mm.

The surface of the light-transmissive substrate on which an emulsion layer is to be formed may have a precision of the same degree as is commonly employed for those light-transmissive substrates which are intended to be used with conventional color filters. But in order to achieve even better image quality, the light-transmissive substrate desirably has a surface precision of ± 0.1 µm.

An anti-halo backing layer is preferably formed on the surface of the light-transmissive substrate on the side opposite to that where a pixel-forming emulsion layer is to be provided. The dye or pigment to be incorporated in the backing layer is preferably non-diffusible and a specific advantageous example is a dispersion of carbon black. Carbon black dispersions may be prepared by either the furnace process or the channel method and "Dia Black" of Mitsubishi Kasei Corp. may be used with particular advantage.

The non-diffusible dye or pigment is incorporated in the backing layer as it is dispersed in a hydrophilic colloid but it must be such that it will not dissolve in any of the processing solutions used after development. The light absorbing characteristics of the dye or pigment used vary with the spectral absorption characteristics of the silver halide emulsion used in the present invention. If a silver halide emulsion that is not spectrally sensitized with a sensitizing dye is to be used, the dye or pigment to be incorporated in the backing layer preferably absorbs light at wavelengths not longer than 500 nm. The backing layer may also contain an ultraviolet (uv) absorbing agent such as "UVINUL MS-40" (BASF A.G.) or "TINUVIN-P" (Ciba-Geigy A.G.).

The non-diffusible dye or pigment and the uv absorbing agent are used in the following manner: they are dissolved in either a known high-boiling point organic solvent or a low-boiling point organic solvent (as typified by methyl acetate, ethyl acetate, propyl acetate, butyl acetate, cyclohexane, tetrahydrofuran, carbon tetrachloride or chloroform) or a mixture thereof; the solution is mixed with an aqueous gelatin solution containing a surfactant; the mixture is then emulsified by dispersing means such as a stirrer, a homogenizer, a colloid mill, a flow-jet mixer or an ultrasonic disperser; and the resulting dispersion is added to a coating composition for applying hydrophilic colloidal backing layer.

The non-diffusible dye or pigment is preferably used in an amount of at least 0.1 mg per 100 $cm^2$ of the light-transmissive substrate, with an amount of at least 1 mg being particularly preferred.

An emulsion layer may be directly coated on the surface of the light-transmissive substrate but if desired, a subbing layer may be provided between the emulsion layer and the light-transmissive substrate. The subbing layer not only enhances the adhesion between the emulsion layer and the light-transmissive substrate but also smoothens the surface of said substrate if it is coarse.

The subbing layer may be made of such materials as gelatin, albumin, casein, cellulose derivatives, starch derivatives, sodium alginate, polyvinyl alcohol, polyvinyl pyrrolidone, polyacrylic acid copolymers, polyvinylidene chloride copolymers, and polyacrylamide. Considering the spectral characteristics of the color filter to be produced, the thickness of the subbing layer is preferably as small as possible and is typically no more than 1 µm, with the range of 0.05 - 0.5 µm being preferred.

The silver halide emulsion layer to be used in the present invention contains at least a silver halide and a water-soluble binder. It may also contain a dye having a dye that displays a silver dye bleaching action.

Illustrative silver halides contain, for example, silver chloride, silver iodide, silver bromide, silver chloroiodide, silver chlorobromide and silver iodobromide. These silver halides may be used either on their own or as admixtures. It is desirable to use silver halides having a small average particle size and it is particularly preferred to use "Lippmann" emulsions having an average grain size of no more than 0.1 µm. The use of silver halide grains having an excessively large size may sometimes cause deterioration in graininess and other characteristics of the image to be obtained with the final color filter.

Illustrative water-soluble binders include, for example, gelatin, albumin, casein, cellulose derivatives, starch derivatives, sodium alginate, polyvinyl alcohol, polyvinyl pyrrolidone, polyacrylic acid copolymers and polyacrylamide. These binders may be used either on their own or as admixtures. Among these binders, gelatin is particularly preferred.

According to a preferred embodiment of the present invention, a dye exhibiting a silver dye bleaching action is contained in a pixel-forming silver halide emulsion layer. Examples of such dyes include phthalocyanine and azo dyes. Among, azo dyes, bisazo dyes are particularly preferred and are specifically

exemplified by the following compounds:

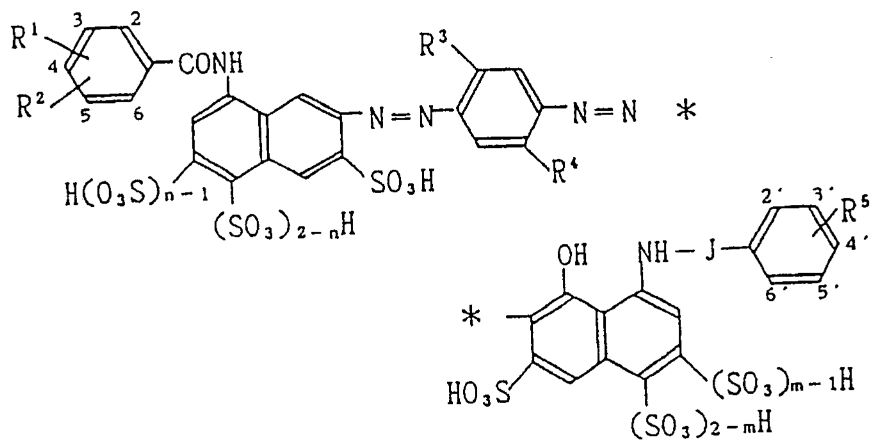

(m and n each represents 1 or 2)

| Compound | $R^1$ | $R^2$ | $R^3$ | $R^4$ | J | $R^5$ |
|---|---|---|---|---|---|---|
| a | 2-$NO_2$ | H | -$OCH_3$ | -$OCH_3$ | -CO- | H |
| b | 2-$NO_2$ | 5-$NO_2$ | -$OCH_3$ | -$OCH_3$ | -CO- | H |
| c | 2-Cℓ | H | -$OCH_3$ | -$OCH_3$ | -CO- | H |
| d | H | H | -$OCH_3$ | -$OCH_3$ | -CO- | H |
| e | 2-Cℓ | H | -$OCH_2CH_2OH$ | H | -$SO_2$- | H |
| f | 2-$SO_2NH_2$ | H | -$OCH_3$ | H | -$SO_2$- | H |
| g | 2-$SO_2CH_3$ | H | -$OCH_3$ | -$OCH_3$ | -CO- | H |
| h | 2-CO-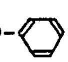 | H | -$OCH_3$ | -$OCH_3$ | -CO- | 4'-Cℓ |
| i | 2-$NO_2$ | H | -$OCH_2CH_2OH$ | H | -$SO_2$- | H |
| j | 2-$COCH_3$ | H | -$OCH_3$ | -$OCH_3$ | -CO- | H |

The silver halide emulsion to be incorporated in the emulsion layer of the color filter of the present invention desirably contains a silver halide, a water-soluble binder and a dye in such proportions that the weight ratio of silver halide to water-soluble binder ranges from 1:6 to 8:1, that the weight ratio of dye to silver halide ranges from 1/10 to 50, and that the weight ratio of dye to water-soluble binder ranges from 1/100 to 2.

The emulsion layer can be formed by applying the emulsion described above onto the light-transmissive substrate also described above by employing a common coating technique such as spinner coating and spray coating.

The thus formed pixel-forming emulsion layer usually has a thickness of from 0.3 to 10 µm on a dry

basis. If the thickness of the emulsion layer is less than 0.3 µm, satisfactory color will sometimes fail to be produced. If the emulsion layer is thicker than 10 µm, light transmission will decrease to cause occasional insufficiency in the lightness of color filter. It is particularly notable in the present invention that the spectral characteristics of the color filter to be obtained can be improved by adjusting the thickness of the emulsion layer to be within the range of from 0.5 to 3 µm.

In a preferred embodiment of the present invention, the emulsion layer described above is used in a silver halide light-sensitive material and processed by the combination of color development and silver dye bleaching. When this combined technique is to be adopted, processing by silver dye bleaching is preferably performed after all steps involved in processing by color development have been completed.

On the pages that follow, the steps involved in processing by color development and those involved in processing by silver dye bleaching as applicable to a preferred embodiment of the present invention are described seriatim.

## Processing by color development

In processing by color development, all the chromatic areas to be formed on the light-transmissive substrate by color development are preferably formed prior to processing by silver dye bleaching. Stated more specifically, the silver halide light-sensitive material described above is subjected to exposure with a mask for pixel formation and thereafter development is performed with a developer containing a color forming coupler so as to form chromatic areas.

### Exposure step

Exposure may be performed by contact exposure, proximity exposure, step exposure and any other methods that are commonly employed in practicing patterned exposure.

An illustrative scheme for performing patterned exposure is depicted in Fig. 1; as shown, a light-transmissive substrate 11 is overlaid with an emulsion layer 12 containing the dye already described which exhibits a silver dye bleaching action; a photomask 14 is placed on a silver halide light-sensitive material 13 consisting of the substrate 11 and the emulsion layer 12; the photomask 14 is illuminated with light from above to expose selected areas 16 of the emulsion layer which correspond to openings 15 in the photomask 14.

The size of the selected areas 16, or openings 15, can be properly selected in accordance with the specific use of the color filter to be produced. If the width of openings 15 is smaller than the wavelength of exposing light source, effective exposure cannot be achieved, so the exposing light source to be used should emit at wavelengths shorter than the width of openings 15. Silver halides are effectively sensitive to light having wavelengths within the range of from 340 to 420 nm, so the width of openings 15 is usually selected to be at least 340 nm, preferably at 1 µm and more when the use of the product as a color filter is taken into account. When the color filter is to be used with a liquid-crystal color display, the width of openings 15 is desirably set at no more than 1,000 µm, particularly at more than 500 µm, in order that effective color reproduction is accomplished by additive mixing of red, blue and green areas.

For other conditions of exposure including exposure time and exposing light source, the usual practice may be complied with.

### Development

Color development is a method in which a dye is taken up or precipitated in the emulsion layer by performing development with a developer incorporating one or more color forming couplers.

The developer to be used in this method contains at least a color forming coupler and a developing agent. A suitable developing agent may be selected from among the compounds described on pages 293 - 298 of C.E.K. Mees and T.H. James, "The Theory of the Photographic Process", 3rd Ed., The Macmillan Company and may specifically be exemplified by the following compounds:

(1) 4-amino-3-methyl-N-(2-hydroxyethyl) aniline sulfate;
(2) N-ethyl-N-methoxyethyl-3-methyl-p-phenylenediamine-p-toluene-sulfonate;
(3) 4-amino-3-methyl-N-ethyl-N-(2-methylsulfonamidoethyl) aniline sulfate hydrate;
(4) N, N-diethyl-p-phenylenediamine sulfate; and

(5) N, N-diethyl-3-methyl-p-phenylenediamine hydrochloride.

A single developing agent is preferably used for incorporation in the developer as selected from among various developing agents including those listed above. Selection of developing agents is usually performed in consideration of the type and combination of color forming couplers used.

A developing agent is generally used in such a way that it is incorporated in the developer in an amount ranging from 0.1 to 10 g per liter of the developer. If the content of developing agent is less than 0.1 g, failure to perform effective development may sometimes occur. Even if more than 10 g of developing agent is used, significant improvement will not be achieved in the efficiency of development. On the contrary, insufficient dissolution may occur depending on the type of developing agent used.

It is preferred to use a developing agent in an amount ranging from 0.5 to 7 g per liter of the developer, with the range of 1 - 5 g being particularly preferred. With the amount of developing agent being set to lie within this range, development can be completed within an appropriate time (say, from one to ten minutes) at ordinary concentrations irrespective of the type of color forming coupler used, and this contributes to marked improvement in operational efficiency. Further, particularly effective color formation is accomplished if the above specified range is selected.

Unlike incorporated couplers (ballasted couplers) which are employed in ordinary color photographic processes, the color forming coupler described above is of a non-incorporated type which is added to a developer and used in such a state that at least part of it is dissolved in the developer. Any known type of non-incorporated couplers may be used for this purpose.

Among the color forming couplers described above, a yellow coupler may be exemplified by ketomethylene compounds such as acyl acetanilides [e.g. α-(4-carboxyphenoxy)-α-pivaloyl-2,4-dichloroacetoanilide]. Other examples that can be used are those which are described in U.S. Patents 3,510,306 and 3,619,189, and Japanese Patent Publication Nos. 40-33775 and 44-3664. Illustrative magenta couplers include active methylene compounds such as pyrazolones (e.g. 1-(2,4,6-trichlorophenyl)-3-(p-nitroanilino)-5-pyrazolone), pyrazoloazoles (e.g. 7-chloro-3-phenyl-6-isopropyl-1H-pyrazolo[5,1-c]-1,2,4-triazole) and cyanoacetanilides. Other examples that can be used are those which are described in OLS 2,016,587, U.S. Patents 3,152,896 and 3,615,502, and Japanese Patent Publication No. 44-133111. Illustrative cyan coupler include phenolic compounds (e.g. 2-acetamido-4,6-dichloro-5-methylphenol) and naphtholic compounds [e.g. N-(2-aqcetamidophenethyl)-1-hydroxy-2-naphthamide]. Other examples that can be used are those which are described in U.S. Patents 3,002,836 and 3,542,552, and British Patent 1,062,190.

Other color forming couplers that can be used in the present invention are described in "The Theory of the Photographic Process", 3rd Ed. (ibid), Chapter 17, pp. 382-395.

The color forming couplers are preferably incorporated in the developer in such amounts that their total sum ranges from 0.1 to 20 g per liter of the developer. If their total sum is less than 0.1 g, insufficient color formation may sometimes occur. If their total sum exceeds 20 g, fogging may sometimes take place. It is particularly notable in the present invention that by adjusting the total sum of color forming couplers in the developer to be within the range of from 0.2 to 10 g per liter of the developer, a color filter that experiences less color contamination and that exhibits satisfactory spectral characteristics can be obtained.

The color couplers that form different colors are incorporated in the developer in proportions that are properly determined in consideration of the efficiency with which they form intended colors. If, for example, a cyan coupler is combined with a magenta coupler, they are incorporated at a weight ratio that usually ranges from 1:9 to 7:3, preferably from 1:9 to 4:6. If a cyan coupler is combined with a yellow coupler, they are incorporated at a weight ratio that usually ranges from 1:9 to 7:3, preferably from 1:9 to 4:6. If a magenta coupler is combined with a yellow coupler, they are incorporated at a weight ratio that usually ranges from 9:1 to 1:9, preferably from 6:4 to 2:8. If three couplers, i.e., cyan, magenta and yellow couplers, are combined, they are preferably incorporated in approximately equal amounts.

The weight ratio of the sum of color forming couplers to the developing agent that are advantageously incorporated in developer to perform color development in the present invention may be properly determined in consideration of such factors as the types and contents of couplers and developing agent. Usually, the weight ratio of color couplers to developing agent is set to lie within the range of from 1:9 to 9:1.

The developer may further contain additives that are commonly incorporated in coupler-containing developers and examples of such additives include preservatives (e.g. sodium sulfite and diethyl hydroxylamine), accelerators (e.g. alkali agents such as sodium hydroxide), control agents (e.g. potassium bromide and potassium iodide), and auxiliaries (e.g. water quality adjusting agents such as polyethylene glycol, and tone modifiers such as citrazinic acid and imidazole derivatives).

The developer can be prepared by dissolving the above described ingredients in water. The prepared developer is used after its pH at ordinary working temperatures (e.g. 10 - 40 °C) is adjusted with a suitable

compound such as sodium hydroxide so that it is within the range from 9.0 to 13.0.

Using the developer described above, pixel formation through processing by color development may proceed in the following manner.

First, the silver halide light-sensitive material described above is subjected to patterned exposure in the usual manner (first exposure). After the first patterned exposure, the exposed area is subjected to first development with a developer containing at least one of the color forming couplers described above. When the developer is a blue developer containing a cyan and a magenta coupler, the exposed area is developed to produce a blue color. If the developer is a green developer containing a cyan and a yellow coupler, the exposed area is developed to produce a green color. If the developer is a red developer containing a magenta and a yellow coupler, the exposed area is developed to produce a red color. If three developers are used, one being a cyan developer containing a cyan coupler, another being a magenta developer containing a magenta coupler and the third being a yellow developer containing a yellow coupler, the exposed area is developed to produce cyan, magenta and yellow colors.

The first exposed area is developed with at least one of the developers described above (i.e., cyan developer, magenta developer, yellow developer, blue developer, green developer and red developer) according to object.

After the first exposed area is developed in the manner described above, the light-sensitive material is usually immersed in a stop solution containing an acid such as acetic acid to stop the reaction that accompanies the development. after subsequent rinsing, the light-sensitive material is immersed in a bleaching solution or a black-and-white developer to prevent color contamination that might occur in the first exposed area during second and subsequent developments. Following the second rinsing, the light-sensitive material is dried to form a first chromatic area having pixels with at least one of red, blue, green, cyan, magenta and yellow colors.

Subsequently, the unexposed area adjacent the first exposed area is subjected to patterned exposure with a mask by the same method as what was employed to effect the first exposure. Thereafter, development is performed using at least one of the developers other than those employed in the first step. If desired, the light-sensitive material may be immersed in a bleaching solution or a black-and-white developer. By subsequent rinsing, drying and other necessary steps, a second chromatic area can be formed.

In a similar way, the unexposed area adjacent the second chromatic area is subjected to patterned exposure and developed with at least one of the developers other than those employed in the first and second steps. If desired, the light-sensitive material may be immersed in a bleaching solution or a black-and-white developer. By subsequent rinsing, drying and other necessary steps, a third chromatic area can be formed.

In a preferred embodiment of the present invention, the formation of first, second and third chromatic areas in the way described above is followed by silver dye bleaching in the manner described below in detail.

## Silver dye bleaching

In this process, the silver halide light-sensitive material on which all the necessary chromatic areas were formed by color development is subjected to silver dye bleaching so that the colors of dyes in said light-sensitive material that exhibit a silver dye bleaching action are removed. The processing by silver dye bleaching involves at least the steps of black-and-white development, dye bleaching and silver bleaching in the order written.

On the pages that follow, these steps of black-and-white development, dye bleaching and silver bleaching as applicable to the processing by silver dye bleaching are described seriatim.

## Black-and-white development

In this step, the light-sensitive material having the chromatic areas formed by color development is exposed imagewise according to the pattern of a desired chromatic area which is one of the previously formed chromatic areas, and the thus exposed area is developed with a black-and- white developer to generate a reduced silver image in the light-sensitive material.

The black-and-white developer used typically contains a developing agent (D), a development aid, a preservative, a "developer antifoggant", an alkali buffer, and optionally solvents for the developing agent (D)

and the development aid.

Illustrative developing agents (D) include hydroquinone, chlorohydroquinone and catechol. Illustrative development aids include pyrazolone, pyrazolone derivatives and Methol. Illustrative preservatives include sulfites and ascorbic acid. Illustrative developer antifoggants include bromides and benzotriazole. Illustrative alkali buffers include carbonates, hydroxides, phosphates, borates and metaborates. Illustrative solvents for the developing agent (D) and development aid include ethylene glycol, triethanol and diethanol.

The contents of the ingredients in the black-and-white developer may typically range as follows: 1 - 20 g/L for developing agent (D); 0.05 - 8 g/L for development aid; 1 -120 g/L for preservative; 0.001 - 5 g/L for developer antifoggant; 0.1 - 50 g/L for alkali buffer; and 1 - 20 ml/L for developing agent and development aid solvents (optional).

Black-and-white development is usually performed by immersing the imagewise exposed light-sensitive material in the black-and-white developer at 20 - 60 °C for 10 - 200 seconds. By the procedure of black-and-white development, a reduced silver image (negative silver image) is generated in the imagewise exposed light-sensitive material (A).

Following the black-and-white development, the light-sensitive material is usually rinsed before it is subjected to dye bleaching in the manner described below.

Dye bleaching

In this step, a dye bleaching solution is used to bleach the dyes incorporated in the light-sensitive material. Stated more specifically, dye bleaching is a process by which those dyes in the imagewise exposed light-sensitive material which contain the greater amount of image-forming silver are bleached to form a positive dye image.

The dye bleaching solution used in this step typically contains a bleaching agent, a compound capable of forming a silver salt or complex, and a dye bleach accelerating catalyst. Illustrative bleaching agents include mineral acids such as hydrochloric acid, sulfuric acid and nitric acid, and organic acids such as sulfamic acid, succinic acid and acetic acid. Illustrative compounds capable of forming a silver salt or complex include potassium bromide, potassium iodide, urea, thiourea, semicarbazide and thiosemicarbazide. Illustrative dye bleach accelerating catalysts include: pyrazine, naphthazine, quinoline, quinoxalines, phenazines, anthraquinones, naphthoquinones, indophenazines, N-substituted isoalloxazines, fluoroquinoxalines, thienoquinoxalines, diphenyl derivatives, triphenylmethane derivatives, lumazines, alloxazines, cinnolines, and orthophenylenediamine derivatives (see U.S. Patents 2,270,118, 2,410,025, 2,541,884, 2,627,461, 2,669,517, British Patents 657,374, 711,247, Japanese Patent Publication No. 45-22195, etc.).

The contents of the ingredients in the dye bleaching solution may typically range as follows: 1 - 20 g/L for bleaching agent; 0.1 - 20 g/L for silver salt or complex forming compound; 0.001 - 10 g/L for dye bleach accelerating catalyst.

Dye bleaching is usually performed by immersing the light-sensitive material in the dye bleaching solution at 20 - 60 °C for 10 - 200 seconds. By the procedure of dye bleaching, more of that area of the imagewise exposed light-sensitive material which contains the greater amount of image-forming silver is bleached to form a positive dye image. In some cases, the black silver that was not utilized in dye bleaching will remain as it is.

Following the dye bleaching, the light-sensitive material is usually rinsed before it is subjected to silver bleaching in the manner described below.

Silver bleaching

Silver bleaching is a process by which all the black silver that remains in the imagewise exposed light-sensitive material after the process of dye bleaching described above is rehalogenized.

A silver bleaching solution is used in this silver bleaching step. The silver bleaching solution used may be of any known type and an advantageous bleaching solution is one that contains a ferric chelate of ethylenediaminetetraacetic acid. Silver bleaching is usually performed at 18 - 60 °C for 5 - 500 seconds.

Following the procedure described above, the light-sensitive material is rinsed and subjected to a fixing treatment to remove any residual silver halides. Thereafter, the light-sensitive material is further rinsed and dried.

Preferred exposure and development process

An exposure and development process that is preferably adopted in the present invention is described below.

Various patterns of exposure and development process that may be employed to form a color filter having pixels B (blue light transmitting pixel), G (green light transmitting pixel) and R (red light transmitting pixel) as shown in Fig. 2 are described in the following Table A.

Table A

| Pattern | $M_1$ | $C_1$ | $Y_1$ | $C_2$ | $Y_2$ | $M_2$ |
|---|---|---|---|---|---|---|
| 1 | GA | SDB | GA | GA | GA | GA |
| 2 | GA | GA | GA | SDB | GA | GA |
| 3 | GA | SDB | GA | SDB | GA | GA |
| 4 | SDB | GA | GA | GA | GA | GA |
| 5 | GA | GA | GA | GA | GA | SDB |
| 6 | SDB | GA | GA | GA | GA | SDB |
| 7 | GA | GA | SDB | GA | GA | GA |
| 8 | GA | GA | GA | GA | SDB | GA |
| 9 | GA | GA | SDB | GA | SDB | GA |

The individual chromatic areas shown in Fig. 2 contain two dyes having different colors as selected from among a yellow dye ($M_1$ Or $M_2$), a magenta dye ($Y_1$ or $Y_2$) and a cyan dye ($C_1$ or $C_2$). Table A illustrates how to form these dyes. Briefly stated, color development is performed to form a dye image in the area indicated by GA in Table A and thereafter the dyes in the areas other than those indicated by SDB are treated by silver dye bleaching to remove the colors of those dyes which exhibit a silver dye bleaching action. This procedure is described below in a more specific way taking as an example the pixel forming pattern identified by 1 in Table A. First, patterned exposure is performed on blue light transmitting pixels by the above-described procedure of the first exposure and development process. Thereafter, development is effected using a developer containing a magenta coupler.

Subsequently, patterned exposure is performed on green light transmitting pixels by the second exposure and development process. Thereafter, development is effected using a developer containing a yellow and a cyan coupler. In the next step, patterned exposure is performed on red light transmitting pixels by the third exposure and development process. Thereafter, development is effected using a developer containing a yellow and a magenta coupler.

In the final step, patterned exposure is performed on green and red light transmitting pixels and thereafter silver dye bleaching is carried out by the procedure already described. The order in which blue, green and red light transmitting pixels are exposed and developed is in no way limited as long as silver dye bleaching is performed after all steps involved in color development have been completed. The layout of the three kinds of pixels also is not limited to that shown in Fig. 2.

In another embodiment of the process of the present invention, a light-transmissive chromatic area 32 consisting of a red region (R), a blue region (B) and a green region (G) is formed on a light-transmissive substrate 31, with a gap being formed between adjacent color regions an shown in Fig. 3. Thereafter, patterned exposure is performed on the gaps, and development is subsequently effected using a developer containing a cyan, a magenta and a yellow color coupler to form a light-opaque zone (black stripe) 33 between any two adjacent regions (R, B and G) of the chromatic area 32. In this case, too, the process of silver dye bleaching is preferably performed after all the steps involved in the process of color development have been completed.

In the process of the present invention, the color filter layer may be etched depending upon the use of color filter so as to remove any unwanted portion of that layer. Further, pixels may be formed in either a mosaic or a striped pattern.

The color filter fabricated by the process described above may advantageously be used with a liquid-crystal color display as shown in Fig. 4, in which the color filter indicated by 43 and a liquid crystal 47 controlled by electrodes 48a and 48b are held between polarizing plates 46a and 46b.

The color filter of the present invention may also be used with advantage in place of the conventionally used color filters in image tubes.

The following examples are provided for further illustrating the present invention but are in no way to be taken as limiting. Unless otherwise noted, all "percentages" that are used in these examples are on a weight basis.

## Example 1

Preparation of silver halide light-sensitive material:

An aqueous solution of silver nitrate and an aqueous solution containing both potassium bromide and potassium iodide were added simultaneously to a 10% aqueous solution of gelatin, thereby preparing a silver iodobromide emulsion (4 mol% AgI; average grain size, 0.05 µm; gelatin concentration, 9%). The conditions of adding the aqueous solutions were so specified as to obtain a Lippmann emulsion having an average grain size of 0.05 µm.

To the resulting silver iodobromide emulsion, sodium thiosulfate ($5H_2O$) was added in an amount of 28.3 g per mole of silver and the mixture was chemically ripened at 59.5 °C for 45 minutes.

Subsequently, 1-phenyl-5-mercaptotetrazole and 1-carboxyethyl-3,4,5-hydroxybenzene were added to the emulsion in respective amounts of 141.5 mg and 3.40 g per mole of silver. At the same time, compound SC-1 (see below) was added in an amount of 15.9 g per mole of silver, followed by addition of two hardeners (compounds H-1 and H-2 as shown below) in respective amounts of 40 mg and 5 mg per gram of gelatin. By this procedure, an emulsion coating solution was prepared.

SC-1

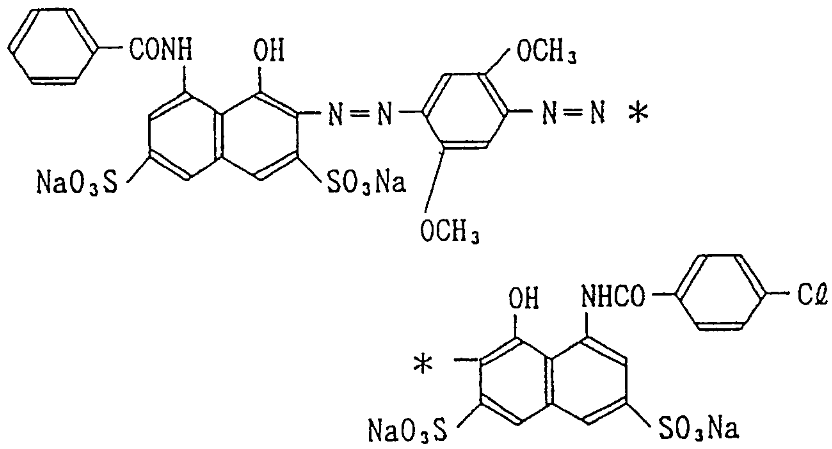

H-1

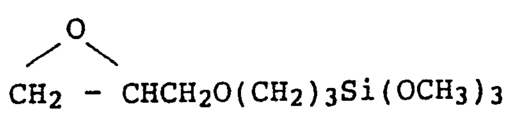

H-2

$$[(CH_2=CHSO_2CH_2)_3CCH_2SO_2CH_2CH_2]_2NCH_2CH_2SO_3K$$

The so prepared emulsion coating solution was applied to a transparent 1.1-mm thick borosilicate glass substrate (30 cm × 30 cm) to give a dry thickness of 3 µm, thereby producing a silver halide light-sensitive material having an emulsion layer. The deposits of silver and dyes on this light-sensitive material were 1.5 g/m$^2$ and 0.24 g/m$^2$, respectively. The so produced light-sensitive material was designated sample No. 1.

Sample Nos. 2 - 9 were produced by the same method as described above except that dispersions containing the compounds listed under HBS in Table 1 (see below) were added to the emulsion coating solution and that the amount of water to be added was so adjusted that the volume of each of the emulsion coating solutions per mole of silver would be equal to that of the emulsion coating solution prepared in the production of sample No. 1. The deposits of silver, dyes and HBS on each of sample Nos. 2 - 9 were 1.5 g/m$^2$, 0.24 g/m$^2$ and 0.1 g/m$^2$, respectively.

The dispersions added to form emulsion coating solutions were prepared by the following procedure: 7.54 g of HBS (see Table 1) was dissolved in 75.7 ml of ethyl acetate; the resulting solution was added and mixed with an aqueous solution containing 15.19 g of gelatin, 94.7 ml of a 5% aqueous solution of sodium triisopropyl-β-naphthalenesulfonate and 254.6 ml of water; the mixture was sonicated at 50 °C and freed of ethyl acetate; finally, water was added to make a total volume of 454.7 ml.

Each of the samples of silver halide light-sensitive material (Nos. 1 - 9) had a backing layer on the surface of the borosilicate glass substrate opposite to the side where the emulsion layer was formed. The backing layer was formed by the following procedure.

A dispersion of compound Y-1 (see below) was added to an aqueous gelatin solution. At the same time, hardeners (H-1 and H-2) were added in respective amounts of 40 mg and 5 mg. The amount of gelatin

preliminarily added to make the aqueous gelatin solution was so adjusted as to provide a gelatin concentration of 5%. ' The amount of Y-1 added to 100 ml of the aqueous gelatin solution was 1.35%.

Y-1

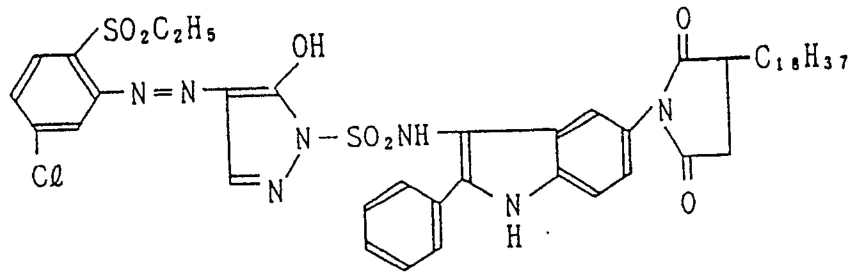

Thereafter, the aqueous gelatin solution was applied to the borosilicate glass substrate and dried to form a backing layer which had Y-1 deposited in an amount of 10 mg/dm$^2$.

The dispersion of Y-1 was prepared by the following procedure: 1 g of Y-1 was dissolved in a mixture of tricresyl phosphate (1 g) and ethyl acetate (4.29 ml); the resulting solution was added and mixed with an aqueous solution containing 0.83 g of gelatin, 2.63 ml of a 5% aqueous solution of sodium triisopropyl-β-naphthalenesulfonate and 8.4 ml of water; the mixture was sonicated at 50° C and freed of ethyl acetate; finally, water was added to make a total volume of 17.6 ml.

Table 1

| Sample No. | HBS |
|---|---|
| 1 | none |
| 2 | tricresyl phosphate (HBS-14) |
| 3 | diethyllauric acid amide (HBS-29) |
| 4 | dioctyl phthalate (HBS-12) |
| 5 | dinonyl phthalate (HBS-10) |
| 6 | diamylphenol (HBS-23) |
| 7 | dinonylphenol (HBS-24) |
| 8 | dioctylphenol (HBS-30) |
| 9 | dibutyl phthalate (HBS-4) |

Fabrication of color filter:

The process of fabricating a color filter is described below on the assumption that it has a mosaic pattern of B (blue), G (green) and R (red) colors as shown in Fig. 2. Each pixel to be formed had a size of 150 µm × 150 µm.

Each of the samples (Nos. 1 - 9) of silver halide light-sensitive material was overlaid with a chromium mask having a mosaic pattern of square openings 150 µm long on each side and subjected to the first cycle of exposure under a tungsten lamp. Exposing light was applied to those positions which corresponded to areas B in Fig. 2.

The exposed light-sensitive material was immersed in a magenta color developer (for its recipe, see below) at 23° C for 3 minutes.

| Magenta Color Developer | | |
|---|---|---|
| Magenta coupler (6-t-butyl-7-chloro-3-(3-methylbutyl)-1H-pyrazolo[3,2-c]-1,2,4-triazole) | | 0.26 g |
| Weiss coupler (WE-20) | | 0.6 g |
| Developing agent (4-amino-3-methyl-N-ethyl-N-β-methanesulfonamidoethylaniline sesqui-sulfate mono-hydrate) | | 2.0 g |
| Sodium nitrilotrimethylenephosphonate (40% aq. sol.) | | 3.00 ml |
| Anhydrous sodium sulfate | | 20.0 g |
| Sodium bromide | | 1.0 g |
| Sodium sulfite | | 10.00 g |
| Ethylene glycol | | 10.0 ml |
| Polyethylene glycol | | 2.0 g |
| Water | to make | 1000.0 ml |

To the magenta color developer described above, sodium hydroxide was added in such an amount that its pH at 25 °C would become 12.0.

Subsequently, the light-sensitive material was rinsed for one minute, bleached by immersion in a silver bleaching solution (for its recipe, see below) for 3 minutes, rinsed for 4 minutes and dried to form a blue region on the substrate (first treatment).

| Silver Bleaching Solution | | |
|---|---|---|
| Ethylenediaminetetraacetic acid iron (III) ammonion salt | | 200.0 g |
| Ammonium bromide | | 10.0 g |
| Glacial acetic acid | | 10.0 ml |
| Water | to make | 1000.0 ml |
| (pH adjusted to 6.0 with aqueous ammonia). | | |

In the next step, another chromium mask was superposed on the light-sensitive material in such a way that areas G shown in Fig. 2 would be exposed, and the light-sensitive material was subjected to the second cycle of exposure.

The thus exposed light-sensitive material was immersed in a yellow color developer (for its recipe, see below) at 23 °C for 3 minutes. Thereafter, it was rinsed for one minute and subsequently bleached, rinsed and dried as in the first treatment to form a green region on the substrate (second treatment).

| Yellow Color Developer | | |
|---|---|---|
| Yellow coupler (α-(4-carboxyphenoxy)-α-pivaloyl-2,4-dichloroacetanilide) | | 1.5 g |
| Developing agent (4-amino-3-methyl-N-ethyl-N-β-methanesulfonamidoethylaniline sesqui-sulfate monohydrate) | | 2.0 g |
| Sodium nitrilotrimethylenephosphonate (40% aq. sol.) | | 3.00 ml |
| Anhydrous sodium sulfate | | 20.0 g |
| Sodium bromide | | 3.0 g |
| Sodium sulfite | | 10.00 g |
| Ethylene glycol | | 10.0 ml |
| Polyethylene glycol | | 2.0 g |
| Water | to make | 1000.0 ml |

To the yellow color developer described above, sodium hydroxide was added in such an amount that its pH at 25 °C would become 12.0.

In the next step, still another chromium mask was superposed on the light-sensitive material in such a way that areas R shown in Fig. 2 would be exposed, and the light-sensitive material was subjected to the third cycle of exposure.

The thus exposed light-sensitive material was immersed in a red color developer (for its recipe, see below) at 23 °C for 3 minutes. Thereafter, it was rinsed, bleached, rinsed and dried as in the second treatment to form a black region on the substrate (third treatment).

| Red Color Developer | | |
|---|---|---|
| Magenta coupler (6-t-butyl-7-chloro-3-(3-methylbutyl)-1H-pyrazolo[3,2-c]-1,2,4-triazole) | | 0.28 g |
| Weiss coupler (WE-20) | | 0.32 g |
| Yellow coupler (α-(4-carboxyphenoxy)-α-pivaloyl-2,4-dichloroacetanilide | | 1.42 g |
| Developing agent (4-amino-3-methyl-N-ethyl-N-β-methanesulfonamidoethylaniline sesqui-sulfate monohydrate) | | 2.0 g |
| Sodium nitrilotrimethylenephosphonate (40% aq. sol.) | | 3.00 ml |
| Anhydrous sodium sulfate | | 20.0 g |
| Sodium bromide | | 3.0 g |
| Sodium sulfite | | 10.00 g |
| Ethylene glycol | | 10.00 ml |
| Polyethylene glycol | | 2.0 g |
| Water | to make | 1000.0 ml |

To the red color developer described above, sodium hydroxide was added in such an amount that its pH at 25 °C would become 12.0.

Subsequently, another chromium mask was superposed on the light-sensitive material in such a way that areas R shown in Fig. 2 would be exposed, and the light-sensitive material was subjected to the fourth cycle of exposure.

The so exposed light-sensitive material was further treated at 33 °C to form a red region (for the scheme of this fourth treatment, see below), thus producing a color filter having a mosaic pattern of B (blue), G (green) and R (red) colors.

| Steps | Time (min) |
|---|---|
| Black-and-white development | 1 |
| Rinsing | 1 |
| Dye bleaching | 1 |
| Rinsing | 1 |
| Silver bleaching | 6 |
| Rinsing | 1 |
| Fixing | 1 |
| Rinsing | 4 |
| Drying | |

The baths used in the individual steps had the following recipes.

| Black-and-white developer | | |
|---|---|---|
| Sodium sulfite | | 10 g |
| Hydroquinone | | 10 g |
| Potassium hydroxide (48% aq. sol.) | | 5 ml |
| Diethylene glycol | | 20 ml |
| Dimezone | | 0.7 g |
| Sodium carbonate | | 20 g |
| Potassium bromide | | 2 g |
| Thiadiazole | | 0.05 g |
| Water | to make | 1000.0 ml |

| Dye bleaching solution | | |
|---|---|---|
| 96% Sulfuric acid | | 40 ml |
| Potassium iodide | | 15 g |
| 2,3,6-Trimethylquinoxaline | | 2 g |
| Water | to make | 1000.0 ml |

| Silver bleaching solution | | |
|---|---|---|
| Pure water | | 800 ml |
| Sodium ferricyanide | | 206 g |
| Sodium bromide | | 15 g |
| Borax | | 1 g |
| Water | to make | 1000.0 ml |
| (pH adjusted to 8.0 with an aqueous solution of potassium hydroxide) | | |

| Fixing solution | | |
|---|---|---|
| Ammonium thiosulfate | | 175.0 g |
| Sodium sulfite | | 8.5 g |
| Sodium metasulfite | | 2.3 g |
| Water | to make | 1000.0 ml |
| (pH adjusted to 6.0 with acetic acid) | | |

After fabricating the color filter, the backing layer was impregnated with a 3% aqueous solution of sodium hypochlorite and completely wiped off with gauze. The thus fabricated color filters were designated sample Nos. 1 - 9.

Additional color filters (sample Nos. 10 - 17) were fabricated by the same procedure as described above except that sample Nos. 1 and 7 of light-sensitive material were used and that the amount of color coupler in the magenta and red color developers, as well as the type and amount of Weiss coupler used therein were changed as shown in Table 2. Sample No. 1 of light-sensitive material was used in fabricating filter sample Nos. 10, 12, 14 and 16, whereas sample No. 7 of light-sensitive material was used in fabricating filter sample Nos. 11, 13, 15 and 17.

Table 2

| Color filter sample No. | Magenta color developer | | | Red color developer | | | |
|---|---|---|---|---|---|---|---|
| | magenta coupler, g/L | Weiss coupler | | magenta coupler, g/L | yellow coupler, g/L | Weiss coupler | |
| | | type | g/L | | | type | g/L |
| 10, 11 | 0.31 | WE•12 | 0.78 | 0.34 | 1.72 | WE•12 | 0.36 |
| 12, 13 | 0.24 | WE•17 | 0.58 | 0.26 | 1.31 | WE•17 | 0.30 |
| 14, 15 | 0.22 | WE•22 | 0.56 | 0.25 | 1.29 | WE•22 | 0.28 |
| 16, 17 | 0.22 | WE•23 | 0.55 | 0.24 | 1.28 | WE•23 | 0.28 |

Additional color filters (sample Nos. 18 - 26) were also fabricated by the same procedure except that the type and amount of couplers and developing agents in magenta, yellow and red color developers were changed as shown in Table 3.

Table 3

| | |
|---|---|
| Magenta color developer | |
| Magenta coupler (6-t-butyl-7-chloro-3-(3-methylbutyl)-1H-pyrazolo[3,2-c]-1,2,4-triazole) | 0.096 g |
| Weiss coupler (WE-20) | 0.215 g |
| Developing agent (4-amino-3-methyl-N,N-diethylaniline hydrochloride) | 1.0 g |
| Yellow color developer | |
| Yellow coupler (α-(4-carboxyphenoxy)-α-pivaloyl-2,4-dichloroacetanilide) | 0.52 g |
| Developing agent (4-amino-3-methyl-N,N-diethylaniline hydrochloride) | 1.0 g |
| Red color developer | |
| Magenta coupler (6-t-butyl-7-chloro-3-(3-methylbutyl)-1H-pyrazolo[3,2-c]-1,2,4-triazole) | 0.172 g |
| Yellow coupler (α-(4-carboxyphenoxy)-α-pivaloyl-2,4-dichloroacetanilide) | 0.46 g |
| Weiss coupler (WE-20) | 0.24 g |
| Developing agent (4-amino-3-methyl-N,N-diethylaniline hydrochloride) | 1.0 g |

The densities of blue and red light transmitting pixels for blue light (B), green light (G) and red light (R) in color filter sample Nos. 1 - 26 were measured with a microdensitometer having a scanning aperture area of 250 $\mu m^2$. The sample-to-sample difference in density for each pixel was small and within the limits of ±3% in terms of density distribution, i.e., (S.D./average density) × 100.

For each sample, the difference in thickness between adjacent pixels and the state of projections on the surface of each pixel were investigated with a Tari Step of Rank Tailor Hobson Co., Ltd. Assuming the absence of projections, the difference in thickness between adjacent pixels was no more than 0.05 μm for all the color filter samples tested. The state of projections on the surface of each pixel is shown in Table 4. Measurement was conducted on each side of a square pixel and on a horizontal center line of the pixel. The number of pixels examined was fifty for each of blue and red light transmitting pixels. The state of projections was evaluated in terms of the average number of projections higher than 0.1 μm and 0.3 μm in one pixels.

Table 4

| Sample No. | Blue light transmitting pixel | | Red light transmitting pixel | |
|---|---|---|---|---|
| | >0.1μm | >0.3μm | >0.1μm | >0.3μm |
| 1 (comparison) | 12 | 4 | 7 | 2 |
| 2 (sample of the invention) | 3 | 0 | 2 | 0 |
| 3 (do.) | 4 | 0 | 3 | 0 |
| 4 (do.) | 3 | 0 | 2 | 0 |
| 5 (do.) | 2 | 0 | 2 | 0 |
| 6 (do.) | 3 | 0 | 2 | 0 |
| 7 (do.) | 2 | 0 | 1 | 0 |
| 8 (do.) | 3 | 0 | 2 | 0 |
| 9 (do.) | 2 | 0 | 2 | 0 |
| 10 (comparison) | 14 | 5 | 9 | 3 |
| 11 (sample of the invention) | 3 | 0 | 2 | 0 |
| 12 (comparison) | 13 | 4 | 8 | 3 |
| 13 (sample of the invention) | 3 | 0 | 2 | 0 |
| 14 (comparison) | 14 | 4 | 8 | 3 |
| 15 (sample of the invention) | 3 | 0 | 2 | 0 |
| 16 (comparison) | 15 | 5 | 9 | 3 |
| 17 (sample of the invention) | 4 | 0 | 2 | 0 |
| 18 (comparison) | 21 | 6 | 12 | 4 |
| 19 (sample of the invention) | 4 | 0 | 2 | 0 |
| 20 (do.) | 5 | 1 | 4 | 0 |
| 21 (do.) | 4 | 0 | 3 | 0 |
| 22 (do.) | 4 | 0 | 3 | 0 |
| 23 (do.) | 4 | 0 | 3 | 0 |
| 24 (do.) | 3 | 0 | 2 | 0 |
| 25 (do.) | 4 | 0 | 4 | 0 |
| 26 (do.) | 3 | 0 | 2 | 0 |

As one can see from Fig. 4, the samples of color filter fabricated in accordance with the present invention had much fewer projections on their surface than the comparative samples.

Thirty minutes after development, the turbidity of magenta and red color developers was measured with a turbidimeter. The developers used in fabricating the color filter samples of the present invention were by far less turbid than those used in fabricating the comparative samples and remained almost transparent.

This tendency was more pronounced when the specimens of the same sample were prepared. a similar measurement was conducted on the tenth specimen and the number of projections on pixels was generally greater than those in the first specimen of each sample. However, the increase was only 0 - 30% in the samples of the present invention and this was much smaller than the increase of 100 - 150% in the comparative samples.

Thus, the color filter of the present invention has a high degree of surface smoothness and can be

produced at low cost since the developers used will experience less fatigue and need not be replaced frequently.

Example 2

Samples (Nos. 101 - 109) of silver halide light-sensitive material were prepared as in Example 1 except that the deposit of HBS on each sample was changed to 0.18 g/m$^2$ and using these samples, color filters were fabricated by the following method.

Fabrication of color filter:

The process of fabricating color filters is described below on the assumption that they have a mosaic pattern of B (blue), G (green) and R (red) colors as shown in Fig. 2. Each pixel to be formed had a size of 150 $\mu$m × 150 $\mu$m.

Each of the samples of silver halide light-sensitive material was overlaid with a chromium mask having a mosaic pattern of square openings 150 $\mu$m long on each side and subjected to the first cycle of exposure under a tungsten lamp. Exposing light was applied to those positions which corresponded to areas B in Fig. 2.

The exposed light-sensitive materials were immersed in a magenta color developer (for its recipe, see below) at 23° C for 3 minutes.

| Magenta Color Developer | | |
|---|---|---|
| Magenta coupler (6-isopropyl-7-chloro-3-phenyl-1H-pyrazolo[3,2-c]-1,2,4-triazole) | | 0.3 g |
| Developing agent (4-amino-3-methyl-N-ethyl-N-$\beta$-methanesulfonamidoethylaniline sesqui-sulfate monohydrate) | | 2.0 g |
| Sodium nitrilotrimethylenephosphonate (40% aq. sol.) | | 3.00 ml |
| Anhydrous sodium sulfate | | 20.0 g |
| Sodium bromide | | 1.0 g |
| Sodium sulfite | | 10.00 g |
| Ethylene glycol | | 10.00 ml |
| Polyethylene glycol | | 2.0 g |
| Water | to make | 1000.0 ml |

To the magenta color developer described above, sodium hydroxide was added in such an amount that its pH at 25° C would become 12.0.

Subsequently, the light-sensitive material were immersed in a stop solution (3% acetic acid in water) for one minute and bleached by immersion in a silver bleaching solution(for its recipe, see Example 1) for 9 minutes, rinsed for one minute and dried to form a blue region on the substrate (first treatment).

In the next step, another chromium mask was superposed on the light-sensitive materials in such a way that areas G shown in Fig. 2 would be exposed, and the light-sensitive materials were subjected to the second cycle of exposure.

The thus exposed light-sensitive materials were immersed in a yellow color developer (for its recipe, see Example 1) at 23° C for 3 minutes. Thereafter, they were immersed in a stop solution (for its recipe, see Example 1) for one minute, rinsed and subsequently bleached, rinsed and dried as in the first treatment to form a green region on the substrate (second treatment).

In the next step, still another chromium mask was superposed on the light-sensitive materials in such a way that areas R shown in Fig. 2 would be exposed, and the light-sensitive materials were subjected to the third cycle of exposure.

The thus exposed photographic materials were immersed in a red color developer (for its recipe, see below) at 23°C for 3 minutes. Thereafter, they were stopped, rinsed, bleached, rinsed and dried to form a black region on the substrate (third treatment).

| Red Color Developer | | |
|---|---|---|
| Magenta coupler (6-isopropyl-7-chloro-3-phenyl-1H-pyrazolo[3,2-c]-1,2,4-triazole) | | 0.3 g |
| Yellow coupler (α-(4-carboxyphenoxy)-α-pivaloyl-2,4-dichloroacetanilide | | 1.5 g |
| Developing agent (4-amino-3-methyl-N-ethyl-N-β-methanesulfonamidoethylaniline sesqui-sulfate monohydrate) | | 2.0 g |
| Sodium nitrilotrimethylenephosphonate (40% aq. sol.) | | 3.00 ml |
| Anhydrous sodium sulfate | | 20.0 g |
| Sodium bromide | | 3.0 g |
| Sodium sulfite | | 10.00 g |
| Ethylene glycol | | 10.00 ml |
| Polyethylene glycol | | 2.0 g |
| Water | to make | 1000.0 ml |

To the red color developer described above, sodium hydroxide was added in such an amount that its pH at 25°C would become 12.0.

Subsequently, another chromium mask was superposed on the light-sensitive materials in such a way that areas R shown in Fig. 2 would be exposed, and the light-sensitive materials were subjected to the fourth cycle of exposure.

The so exposed light-sensitive materials were further treated at 33°C to form a red region (for the scheme of this fourth treatment, see below), thus producing a color filters each having a mosaic pattern of B (blue), G (green) and R (red) colors.

| Steps | Time (min) |
|---|---|
| Black-and-white development | 1 |
| Stopping | 1 |
| Rinsing | 1 |
| Dye bleaching | 1 |
| Rinsing | 1 |
| Silver bleaching | 1 |
| Rinsing | 1 |
| Fixing | 1 |
| Rinsing | 4 |
| Drying | |

The baths used in the individual steps were the same as those employed in Example 1.

After fabricating the color filters, the backing layer was impregnated with a 3% aqueous solution of sodium hypochlorite and completely wiped off with gauze. The thus fabricated color filters were designated sample Nos. 101 -109.

Additional color filters (sample Nos. 110 - 118) were fabricated by the same procedure as described above except that the type and amount of couplers and developing agents in magenta, yellow and red color developers were changed as shown in Table 5.

Table 5

| Magenta color developer | |
|---|---|
| Magenta coupler (6-isopropyl-7-chloro-3-phenyl-1H-pyrazolo[3,2-c]-1,2,4-triazole)<br>Developing agent (4-amino-3-methyl-N,N-diethylaniline hydrochloride) | 0.1 g<br>0.3 g |
| Yellow color developer | |
| Yellow coupler (α-(4-carboxyphenoxy)-α-pivaloyl-2,4-dichloroacetanilide)<br>Developing agent (4-amino-3-methyl-N,N-diethylaniline hydrochloride) | 1.0 g<br>1.2 g |
| Red color developer | |
| Magenta coupler (6-isopropyl-7-chloro-3-phenyl-1H-pyrazolo[3,2-c]-1,2,4-triazole)<br>Yellow coupler (α-(4-carboxyphenoxy)-α-pivaloyl-2,4-dichloroacetanilide)<br>Developing agent (4-amino-3-methyl-N,N-diethylaniline hydrochloride) | 0.23 g<br>1.2 g<br>1.2 g |

The densities of blue and blue light transmitting pixels for blue light (B), green light (G) and red light (R) in color filter sample Nos. 101 - 118 were measured with a microdensitometer having a scanning aperture area of 250 $\mu m^2$. The values of B/G (the ratio of density measured for blue light to that measured for green light) are shown in Table 6. The smaller these values, the better the fidelity of color reproduction.

Sample Nos. 101 - 118 were tested for their heat resistance by heating them in an oven at 180°C for 2, 4 and 6 hours. The changes in the density of blue and red light transmitting pixels for either blue or green light were measured and the results are described in Table 7-1 (for blue-light transmitting pixels) and Table 7-2 (for red-light transmitting pixels) in terms of relative values with the density in the virgin sample being taken as one. The data for red light transmitting pixels as obtained with blue light are omitted from Table 7-2.

Table 6

| Sample No. | B/G | Sample No. | B/G |
|---|---|---|---|
| 101 (comparison) | 0.32 | 110 (comparison) | 0.30 |
| 102 (sample of the invention) | 0.16 | 111 (sample of the invention) | 0.13 |
| 103 (do.) | 0.15 | 112 (do.) | 0.15 |
| 104 (do.) | 0.16 | 113 (do.) | 0.16 |
| 105 (do.) | 0.18 | 114 (do.) | 0.18 |
| 106 (do.) | 0.15 | 115 (do.) | 0.14 |
| 107 (do.) | 0.14 | 116 (do.) | 0.13 |
| 108 (do.) | 0.15 | 117 (do.) | 0.15 |
| 109 (do.) | 0.15 | 118 (do.) | 0.14 |

Table 7-1

| Sample No. | Change in density for blue light | | | Change in density for green light | | |
|---|---|---|---|---|---|---|
| | 2 h | 4 h | 6 h | 2 h | 4 h | 6 h |
| 101 (comparison) | 1.25 | 1.60 | 1.80 | 0.94 | 0.87 | 0.80 |
| 102 (sample of the invention) | 1 | 1 | 1.05 | 0.98 | 0.95 | 0.92 |
| 103 (do.) | 1 | 1.05 | 1.10 | 0.98 | 0.95 | 0.92 |
| 104 (do.) | 1.05 | 1.05 | 1.10 | 0.97 | 0.94 | 0.90 |
| 105 (do.) | 1.05 | 1.05 | 1.10 | 0.96 | 0.93 | 0.90 |
| 106 (do.) | 1 | 1.05 | 1.05 | 0.98 | 0.95 | 0.92 |
| 107 (do.) | 1 | 1 | 1.05 | 0.99 | 0.98 | 0.97 |
| 108 (do.) | 1 | 1 | 1.07 | 0.98 | 0.96 | 0.94 |
| 109 (do.) | 1 | 1 | 1.05 | 0.98 | 0.97 | 0.94 |
| 110 (comparison) | 1.20 | 1.55 | 1.70 | 0.96 | 0.91 | 0.85 |
| 111 (sample of the invention) | 1 | 1 | 1.00 | 0.99 | 0.98 | 0.96 |
| 112 (do.) | 1 | 1.05 | 1.05 | 0.98 | 0.96 | 0.94 |
| 113 (do.) | 1 | 1.05 | 1.10 | 0.98 | 0.96 | 0.94 |
| 114 (do.) | 1 | 1.05 | 1.10 | 0.98 | 0.96 | 0.94 |
| 115 (do.) | 1 | 1 | 1.05 | 0.99 | 0.98 | 0.96 |
| 116 (do.) | 1 | 1 | 1.05 | 0.98 | 0.97 | 0.96 |
| 117 (do.) | 1 | 1.05 | 1.10 | 0.97 | 0.96 | 0.94 |
| 118 (do.) | 1 | 1 | 1.07 | 0.97 | 0.95 | 0.94 |

Table 7-2

| Sample No. | Change in density for green light | | |
|---|---|---|---|
| | 2 h | 4 h | 6 h |
| 101 (comparison) | 0.93 | 0.86 | 0.79 |
| 102 (sample of the invention) | 0.97 | 0.94 | 0.91 |
| 103 (do.) | 0.98 | 0.95 | 0.92 |
| 104 (do.) | 0.97 | 0.94 | 0.90 |
| 105 (do.) | 0.96 | 0.92 | 0.89 |
| 106 (do.) | 0.97 | 0.94 | 0.91 |
| 107 (do.) | 0.98 | 0.97 | 0.96 |
| 108 (do.) | 0.97 | 0.96 | 0.94 |
| 109 (do.) | 0.97 | 0.95 | 0.94 |
| 110 (comparison) | 0.95 | 0.90 | 0.84 |
| 111 (sample of the invention) | 0.99 | 0.98 | 0.95 |
| 112 (do.) | 0.98 | 0.96 | 0.93 |
| 113 (do.) | 0.98 | 0.95 | 0.93 |
| 114 (do.) | 0.98 | 0.95 | 0.93 |
| 115 (do.) | 0.99 | 0.98 | 0.95 |
| 116 (do.) | 0.98 | 0.97 | 0.97 |
| 117 (do.) | 0.97 | 0.96 | 0.95 |
| 118 (do.) | 0.98 | 0.97 | 0.96 |

As is clear from Table 6, the color filter samples of the present invention had smaller values of B/G in blue light transmitting pixels and were capable of reproducing colors with better fidelity.

As is clear from Tables 7-1 and 7-2, the samples of the present invention had better heat resistance and their blue light transmitting pixels experienced a smaller increase in blue density upon heat treatment and thus were capable of reproducing colors with better fidelity after the heat treatment.

Example 3

Additional color filters which were the same as sample Nos. 102 - 109 and 111 - 118 (see Table 7-1) were fabricated as in Example 2 except that the deposit of HBS in each of the light-sensitive materials used was adjusted to 0.001, 0.01, 0.05, 1, 2 or 5 g/m$^2$. These color filter samples were subjected to a heat resistance test as in Example 2 in order to investigate the changes in density that occurred in blue and green light transmitting pixels. Barring slight variations between samples, the results were essentially the same as obtained in Example 2 when the HBS deposit of 0.001 g/m$^2$ did not experience as great a change in density as comparative sample No. 101 or 110 when they were subjected to a heat resistance test. However, they were not as heat-resistant as the samples having a HBS deposit of 0.01, 0.05, 1 or 2 g/m$^2$ since they experienced a comparatively great change in density. The samples having a HBS deposit of 5 g/m$^2$ not only devitrified but also developed many fine cracks in the surface of color filters. Hence, these samples were not suitable for practical use as color filters.

**Claims**

1. A color filter having a plurality of pixels of different colors on a light-transmissive substrate wherein at least one of said pixels contains a dye formed from a dye-forming coupler in a developer and 0.1 - 20 mg/dm$^2$ of a high-boiling point organic solvent.

2. A color filter according to claim 1 wherein said high-boiling point organic solvent is selected from among phthalic acid esters, phosphoric acid esters and phenolic compounds.

3. A color filter according to claim 2 herein said phthalic acid esters are compounds represented by the following general formula (I):

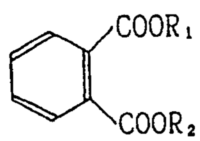

(I)

where $R_1$ and $R_2$ each represents an alkyl group, an alkenyl group or an aryl group, provided that the sum of carbon atoms in $R_1$ and $R_2$ ranges from 2 to 36.

4. A color filter according to claim 2 wherein said phosphoric acid esters are compounds represented by the following general formula (II):

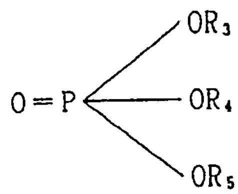

(II)

where $R_3$, $R_4$ and $R_5$ each represents an alkyl group, an alkenyl group or an aryl group, provided that the sum of carbon atoms in the $R_3$, $R_4$ and $R_5$ ranges from 3 to 54.

5. A color filter according to claim 2 wherein said phenolic compounds are represented by the following general formula (III):

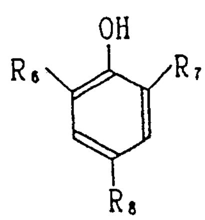

(III)

where $R_6$ and $R_7$ each represents a hydrogen atom or an alkyl group having 1 - 20 carbon atoms and $R_8$ represents an alkyl or cycloalkyl group having 1 - 20 carbon atoms, provided that the sum of carbon atoms in $R_6$, $R_7$ and $R_8$ ranges from 6 to 24.

6. A color filter according to claim 1 wherein said high-boiling point organic solvent is contained in a light-sensitive emulsion layer in an amount of 0.5 - 10 mg/dm$^2$.

7. A color filter according to claim 1 wherein said developer contains a high-boiling point organic solvent in an amount of 0.1 - 30 g per liter.

8. A color filter according to claim 1 wherein at least one substantially colorless compound that is formed upon coupling reaction between a precursor compound represented by the following general formula (IV) and the oxidized product of a color developing agent is contained in at least one of said pixels:

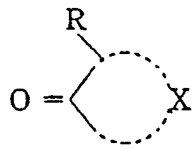

(IV)

where R represents an alkyl or aryl group substituted on the active site, and X represents the atomic group necessary to form a 5- or 6-membered heterocyclic nucleus containing at least one nitrogen, sulfur or oxygen atom.

9. A color filter according to claim 8 wherein said precursor compound is a compound represented by either one of the following general formulas (1) to (8):

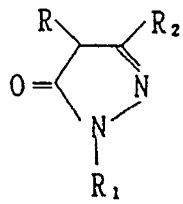

(1)

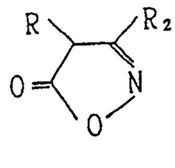

(2)

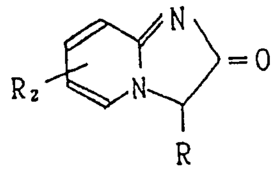

(3)

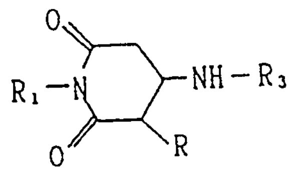

(4)

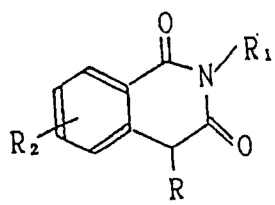

(5)

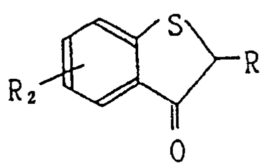

(6)

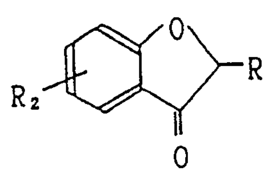

(7)

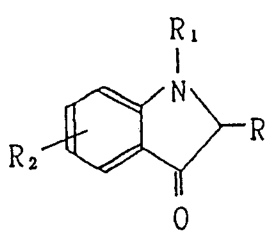

(8)

where R is the same as defined for the general formula (IV); $R_1$ is an alkyl or aryl group; $R_2$ is an alkyl, aryl, alkylamino, arylamino, acylamino, ureido, cyano or carbamoyl group; $R_3$ is an alkyl or aryl group.

10. A color filter according to claim 8 wherein said precursor compound is a compound represented by the following general formula (9):

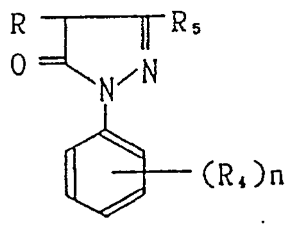

(9)

where R is the same as defined for the general formula (IV); $R_4$ is a hydrogen atom, a halogen atom, an alkyl, alkoxy, alkylamido, arylamido, alkylsulfonamido, arylsulfonamido, alkoxycarbonyl, carbamoyl or sulfamoyl group; $R_5$ is an alkyl group having no more than 8 carbon atoms, an aralkyl or aryl group having no more than 10 carbon atoms; and n is an integer of 0 - 5.

11. A color filter according to claim 8 wherein said precursor compound is contained in a processing solution for color development in an amount of no more than 10 g per liter of said solution.

12. A color filter according to claim 8 wherein said precursor compound is contained in a processing solution for color development in an amount of 0.01 - 2 g per liter of said solution.

13. A color filter according to claim 1 wherein said light-transmissive substrate is made of a heat-resistant material.

14. A color filter according to claim 1 wherein said light-transmissive substrate is made of glass having a thickness of 0.3 - 2 mm.

15. A color filter according to claim 1 wherein an anti-halo backing layer is formed on the surface of said light-transmissive substrate which is opposite to the side where the pixels are provided.

16. A color filter according to claim 15 wherein said backing layer contains a non-diffusible dye or pigment.

17. A color filter according to claim 1 wherein said pixels contain a dye having a silver dye bleaching action.

18. A color filter according to claim 17 wherein said dye is a phthalocyanine or azo dye.

19. A color filter according to claim 1 wherein said pixels have a thickness of 0.5 - 3 $\mu$m.

20. A color filter according to claim 1 wherein said pixels have a red color and yellow and magenta dyes are formed from dye-forming couplers in said developer.

21. A color filter according to claim 17 wherein said pixels have a green color, a yellow dye is formed from a dye-forming coupler in said developer, and said dye having a silver dye bleaching action is cyan.

22. A color filter according to claim 17 wherein said pixels have a blue color, a magenta dye is formed from a dye-forming coupler in said developer, and said dye having a silver dye bleaching action is cyan.

23. A color filter for use with a liquid-crystal color display which has a plurality of pixels of different colors on a light-transmissive substrate wherein at least one of said pixels contains both a dye formed from a dye-forming coupler in a developer and a high-boiling point organic solvent.

24. A process for producing a color filter having a plurality of pixels of different colors on a support, which process includes at least one step of development with a color developer containing a dye-forming coupler in the presence of a high-boiling point organic solvent subsequent to patterned exposure of a light-sensitive material having a light-sensitive silver halide emulsion layer on a light-transmissive support.

25. A process according to claim 24 wherein said high-boiling point organic solvent is contained in the light-sensitive material.

26. A process according to claim 25 wherein said high-boiling point organic solvent is contained in the light-sensitive material in an amount of 0.1 - 20 mg/dm$^2$.

27. A process according to claim 25 wherein said high-boiling point organic solvent is contained in the light-sensitive material in an amount of 0.5 - 10 mg/dm$^2$.

28. A process according to claim 24 wherein said high-boiling point organic solvent is contained in a color developer in an amount of 0.1 - 30 g per liter of said developer.

29. A process according to claim 24 wherein said silver halide emulsion layer contains a dye having a silver dye bleaching action.

30. A process according to claim 24 which further includes a step[ of treatment by silver dye bleaching.

31. A process according to claim 30 wherein the treatment by silver dye bleaching is performed after all the steps involved in processing with said color developer have been completed.

32. A process according to claim 24 wherein said color developer contains a precursor compound represented by the following general formula (IV):

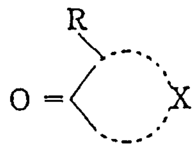

(IV)

where R represents an alkyl or aryl group substituted on the active site, and X represents the atomic group necessary to form a 5- or 6-membered heterocyclic nucleus containing at least one nitrogen, sulfur or oxygen atom.

33. A process according to claim 32 wherein said precursor compound is contained in either a color developer or a black-and-white developer capable of silver dye bleaching.

34. A process according to claim 32 wherein said precursor compound is contained in a processing solution for color development in an amount of no more than 10 g per liter of said solution.

35. A process according to claim 32 wherein said precursor compound is contained in a processing solution for color development in an amount of 0.01 - 2 g per liter of said solution.

36. A process according to claim 24 wherein said patterned exposure is performed with a photomask having openings no smaller than 1 μm.

37. A process according to claim 36 wherein said patterned exposure is performed with a photomask having openings no larger than 1000 μm.

38. A process according to claim 24 wherein said color developer contains a developing agent in an amount of 0.5 -7 g/L.

39. A process according to claim 24 wherein said color developer contains color forming couplers in a total amount of 0.1 - 20 g/L.

Fig.1

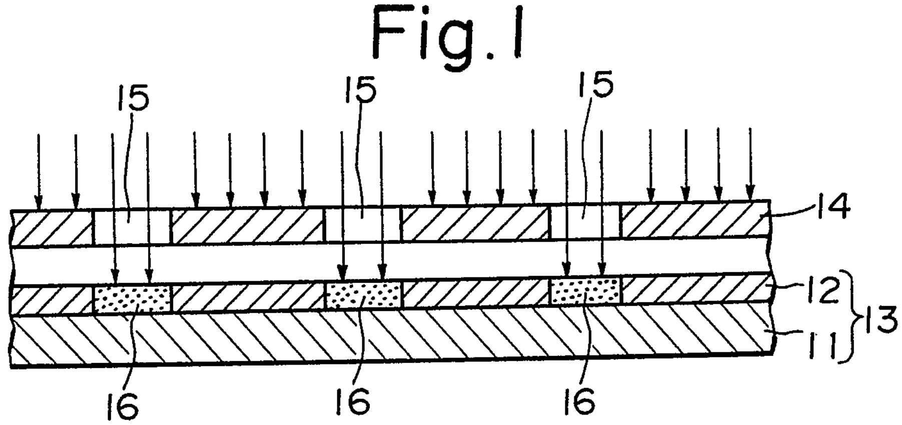


Fig.2

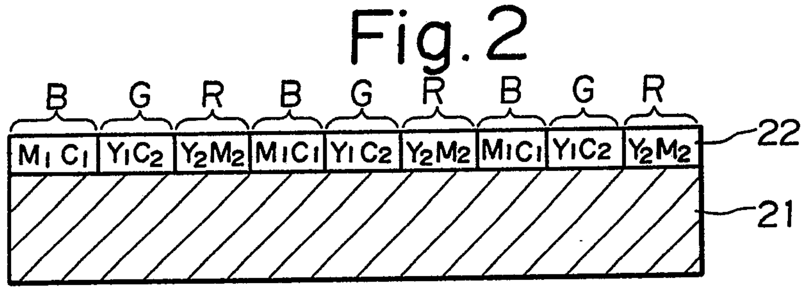


Fig.3

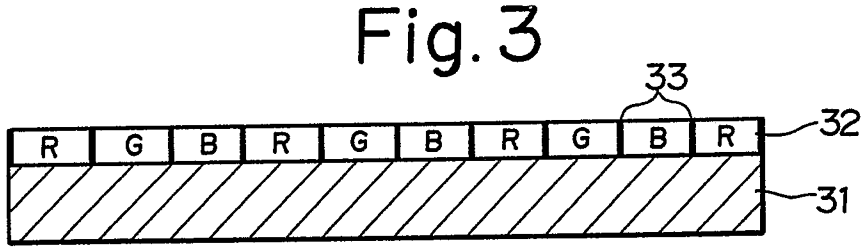

Fig.4

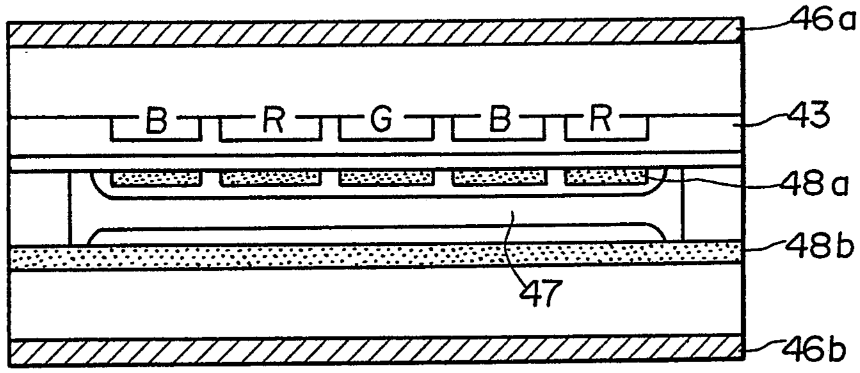

European Patent Office

# EUROPEAN SEARCH REPORT

Application Number

EP 90 30 0421

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X,Y<br>D | US-A-4 271 246 (SATO et al.)<br>* Column 1, lines 56-68; column 3, lines 50,51; column 4, lines 9-11,15-19,61-63; column 6, lines 13-15; column 10, line 42 * & JP-A-55 6342 | 1-39 | G 03 C 7/12<br>H 01 L 31/0216<br>G 02 F 1/1335 |
| X,Y | EP-A-0 257 451 (AGFA-GEVAERT)<br>* Pages 17-19; page 20, lines 1-35; page 24, table 1; page 25, line 50; page 26, line 3; claim 1 * | 1-39 | |
| X,Y | EP-A-0 277 385 (AGFA-GEVAERT)<br>* Page 4, line 36 - page 5, line 50; page 7, line 58 - page 8, line 8; page 12, lines 48-58; claims * | 1-39 | |
| X,Y | US-A-4 375 507 (WHITMORE)<br>* Column 10, lines 51-68; column 34, lines 1-14; column 45, lines 53-60; column 47, lines 15-38; column 84, lines 1-13 * | 1-39 | **TECHNICAL FIELDS SEARCHED (Int. Cl.5)** |
| Y | US-A-4 294 900 (AONO)<br>* Column 17, lines 23-34,49-57; column 20, lines 15-19; column 21, lines 37-51; column 23, lines 27-37 * | 1-39 | G 03 C 7 |
| Y | DE-A-3 133 164 (FUJI)<br>* Page 15, lines 15-35; page 21, lines 9-26; page 23, lines 11-31 * | 1-39 | |
| Y | US-A-4 386 143 (SATO et al.)<br>* Claims * | 1-39 | |
| Y | US-A-4 678 740 (CATANIA)<br>* Claims *<br>--- -/- | 1-39 | |

The present search report has been drawn up for all claims

| Place of search | Date of completion of the search | Examiner |
|---|---|---|
| THE HAGUE | 23-02-1990 | MAGRIZOS S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

European Patent Office

# EUROPEAN SEARCH REPORT

Application Number

EP 90 30 0421

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | PATENT ABSTRACTS OF JAPAN, vol. 7, no. 220 (P-226)[1365], 30th September 1983; JP-A-58 111 906 (MISTUBISHI) 04-07-1983<br>* Abstract *<br>----- | 1,14 | |

TECHNICAL FIELDS SEARCHED (Int. Cl.5)

The present search report has been drawn up for all claims

| Place of search | Date of completion of the search | Examiner |
|---|---|---|
| THE HAGUE | 23-02-1990 | MAGRIZOS S. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document